(19) Europäisches Patentamt European Patent Office Office européen des brevets

(11) **EP 4 723 163 A1**

(12) **EUROPEAN PATENT APPLICATION**
published in accordance with Art. 153(4) EPC

(43) Date of publication:
**08.04.2026 Bulletin 2026/15**

(21) Application number: **24815133.4**

(22) Date of filing: **09.05.2024**

(51) International Patent Classification (IPC):
*H01L 21/304* [(2006.01)]   *B23K 26/00* [(2014.01)]
*B23K 26/08* [(2014.01)]   *B23K 26/53* [(2014.01)]

(52) Cooperative Patent Classification (CPC):
**H10P 52/00; B23K 26/0006; B23K 26/53**

(86) International application number:
**PCT/JP2024/017303**

(87) International publication number:
**WO 2024/247649 (05.12.2024 Gazette 2024/49)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.05.2023 JP 2023087816**

(71) Applicant: **DENSO CORPORATION
Kariya-city, Aichi 448-8661 (JP)**

(72) Inventors:
• **TAKAGI Ryota
Kariya-city, Aichi 4488661 (JP)**

• **YASUDA Koichiro
Kariya-city, Aichi 4488661 (JP)**
• **SHIMOGORI Gaku
Kariya-city, Aichi 4488661 (JP)**
• **TAKEUCHI Yuto
Kariya-city, Aichi 4488661 (JP)**
• **KAWAZU Tomoki
Kariya-city, Aichi 4488661 (JP)**

(74) Representative: **Kuhnen & Wacker
Patent- und Rechtsanwaltsbüro PartG mbB
Prinz-Ludwig-Straße 40A
85354 Freising (DE)**

(54) **LASER MACHINING METHOD AND WAFER MANUFACTURING METHOD**

(57) By performing a laser scan, which includes moving an irradiation position (PR) of a laser beam (B) along a first direction (Ds) while irradiating a surface (21) of a machining target (2) with the laser beam, for a plurality of times with changes in position within the surface in a second direction (Df), a plurality of irradiation trajectory lines (Ls) are formed along the second direction, the second direction being orthogonal to the first direction and defined along the surface, the irradiation trajectory lines being made of irradiation marks of the laser beam and linear along the first direction. In the single laser scan, the irradiation marks are formed at a plurality of the respective irradiation positions by intermittently irradiating with the laser beam with a relative movement of the laser beam relative to the machining target along the first direction, and the irradiation marks formed by the irradiation with the laser beam that precedes are irradiated with the laser beam that follows.

FIG.7D

## Description

[Cross-Reference to Related Application]

This application is based on Japanese Patent Application No. 2023-87816 filed May 29, 2023, the description of which is incorporated herein by reference.

[Technical Field]

The present disclosure relates to a laser machining method for a machining target made of a semiconductor material and a wafer manufacturing method using the same.

[Background Art]

PTL 1 provides a wafer generation method enabling efficiently generating a wafer from an ingot. Specifically, the wafer generation method described in PTL 1 includes a separation starting point forming step and a wafer separation step. In the separation starting point forming step, a focal point of a laser beam having a wavelength to which a hexagonal monocrystal ingot is transparent is positioned at a depth equivalent to a thickness of a wafer being generated from a surface, and the focal point and the ingot are relatively moved to irradiate the surface with the laser beam. This forms a modified layer and a separation layer, which includes cracks extending from the modified layer, inside the ingot. In the wafer separation step, a hexagonal monocrystal wafer is generated by separating a plate-shaped object equivalent to the thickness of the wafer from the ingot at the separation layer, which is a separation starting point.

[Citation List]

[Patent Literature]

[PTL 1] JP 6482389 B

[Summary of the Invention]

The wafer generation method described in PTL 1 may occur the occurrence of variation in a formation depth of the modified layer. The occurrence of variation in the formation depth of the modified layer leads to an increase in a machining allowance for grinding or polishing due to a step formed in the separation surface or the occurrence of separation failure, which lowers manufacturing efficiency. The present disclosure has been made in view of the circumstances exemplified above, or the like. That is to say, the present disclosure provides, for example, a technology that reduces variation in a formation depth of a modified layer or a separation layer.

It should be noted that some elements are designated by reference numerals in parentheses in sections herein. In this case, reference numerals indicate merely examples of correspondence relationships between elements and specific components described in a later-described embodiment. Accordingly, the present disclosure is by no means limited by the description of the reference numerals.

According to an aspect of the present disclosure, a laser machining method is a method of irradiating a machining target made of a semiconductor material with a laser beam, the method including

   a modified layer formation in which a modified layer is formed at a predetermined depth from a surface of the machining target by irradiating the surface with the laser beam which is transmissive to the surface, in which
   in the modified layer formation,
   by performing a laser scan for a plurality of times with a change in position within the surface in a second direction, a plurality of irradiation trajectory lines are formed along the second direction, the laser scan including irradiating the surface with the laser beam while moving an irradiation position of the laser beam within the surface along a first direction defined along the surface, the second direction being orthogonal to the first direction and defined along the surface, the irradiation trajectory lines being made of irradiation marks of the laser beam and linear along the first direction, and
   in a single laser scan, the irradiation marks are formed at a plurality of the respective irradiation positions by intermittently irradiating with the laser beam with a relative movement of the laser beam relative to the machining target along the first direction, and the irradiation marks formed by the irradiation with the laser beam that precedes are irradiated with the laser beam that follows.

According to another aspect of the present disclosure, a wafer manufacturing method is a method of obtaining a wafer from an ingot, the method including

   a separation layer formation in which a separation layer is formed at a depth corresponding to a thickness of the wafer from a surface of the ingot on one end side in a height direction by irradiating the surface with a laser beam which is transmissive to the surface, in which
   in the separation layer formation,
   the separation layer is formed by performing a laser scan for a plurality of times with a change in position within the surface in a second direction to form a plurality of irradiation trajectory lines along the second direction, the laser scan including irradiating the surface with the laser beam while moving an irradiation position of the laser beam within the surface along a first direction defined along the surface, the second direction being orthogonal to the first direction and defined along the surface, the irradiation trajectory lines being made of irradiation marks of the laser beam and linear along the first direction, and in a single laser scan, the irradiation marks are formed at a plurality of the respective irradiation positions by intermittently irradiating with the laser beam with a relative movement of the laser beam relative to the ingot along the first direction, and the irradiation marks formed by the irradiation with the laser beam that precedes are irradiated with the laser beam that follows.

According to still another aspect of the present disclosure, a laser machining method is a method of irradiating a machining target made of a semiconductor material with a laser beam, the method including

a modified layer formation in which a modified layer is formed at a predetermined depth from a surface of the machining target by irradiating the surface with the laser beam which is transmissive to the surface, in which
in the modified layer formation,
by performing a laser scan for a plurality of times with a change in position within the surface in a second direction, a plurality of irradiation trajectory lines are formed along the second direction, the laser scan including irradiating the surface with the laser beam while moving an irradiation position of the laser beam within the surface along a first direction defined along the surface, the second direction being orthogonal to the first direction and defined along the surface, the irradiation trajectory lines being made of irradiation marks of the laser beam and linear along the first direction, and
in a single laser scan, the irradiation marks are formed at a plurality of the respective irradiation positions by intermittently irradiating with the laser beam with a relative movement of the laser beam relative to the machining target along the first direction, and a portion between a pair of the irradiation marks formed by an irradiation with a preceding beam and arrayed along the first direction is subjected to an irradiation with a following beam, the preceding beam being the laser beam that precedes, the following beam being the laser beam that follows.

According to yet another aspect of the present disclosure, a wafer manufacturing method is a method of obtaining a wafer from an ingot, the method including

a separation layer formation in which a separation layer is formed at a depth corresponding to a thickness of the wafer from a surface of the ingot on one end side in a height direction by irradiating the surface with a laser beam which is transmissive to the surface, in which
in the separation layer formation,
the separation layer is formed by performing a laser scan for a plurality of times with a change in position within the surface in a second direction to form a plurality of irradiation trajectory lines along the second direction, the laser scan including irradiating the surface with the laser beam while moving an irradiation position of the laser beam within the surface along a first direction defined along the surface, the second direction being orthogonal to the first direction and defined along the surface, the irradiation trajectory lines being made of irradiation marks of the laser beam and linear along the first direction, and in a single laser scan, the irradiation marks are formed at a plurality of the respective irradiation positions by intermittently irradiating with the laser beam with a relative movement of the laser beam relative to the ingot along the first direction, and a portion between a pair of the irradiation marks formed by an irradiation with a preceding beam and arrayed along the first direction is subjected to an irradiation with a following beam, the preceding beam being the laser beam that precedes, the following beam being the laser beam that follows.

[Brief Description of the Drawings]

Fig. 1 is a side view illustrating an outline of a wafer manufacturing method according to an embodiment of the present disclosure.
Fig. 2 is a flowchart illustrating the outline of the wafer manufacturing method.
Fig. 3 is a side view illustrating an outline of a separation-layer formation step illustrated in Fig. 2, that is, a laser machining method according to an embodiment of the present disclosure.
Fig. 4 is a plan view illustrating a schematic configuration of an ingot having been subjected to the separation-layer formation step illustrated in Fig. 2 and Fig. 3.
Fig. 5A is a diagram illustrating a formation status of an irradiation mark in a case where a laser beam is scanned in a direction orthogonal to an off-angle direction in a wafer manufacturing method of Comparative Example 1.
Fig. 5B is a diagram illustrating the formation status of the irradiation mark in the case where the laser beam is scanned in a direction orthogonal to the off-angle direction in the wafer manufacturing method of Comparative Example 1.
Fig. 6A is a diagram illustrating a formation status of an irradiation mark in a case where a laser beam is scanned in the off-angle direction in the wafer manufacturing method of Comparative Example 2.
Fig. 6B is a diagram illustrating the formation status of the irradiation mark in the case where the laser beam is scanned in the off-angle direction in the wafer manufacturing method of Comparative Example 2.

Fig. 6C is a diagram illustrating the formation status of the irradiation mark in the case where the laser beam is scanned in the off-angle direction in the wafer manufacturing method of Comparative Example 2.

Fig. 6D is a diagram illustrating the formation status of the irradiation mark in the case where the laser beam is scanned in the off-angle direction in the wafer manufacturing method of Comparative Example 2.

Fig. 6E is a close-up optical micrograph showing a modified layer formed by the wafer manufacturing method of Comparative Example 2.

Fig. 7A is a diagram illustrating a formation status of an irradiation mark in the wafer manufacturing method according to an embodiment of the present disclosure.

Fig. 7B is a diagram illustrating the formation status of the irradiation mark in the wafer manufacturing method according to an embodiment of the present disclosure.

Fig. 7C is a diagram illustrating the formation status of the irradiation mark in the wafer manufacturing method according to an embodiment of the present disclosure.

Fig. 7D is a diagram illustrating the formation status of the irradiation mark in the wafer manufacturing method according to an embodiment of the present disclosure.

Fig. 7E is a close-up optical micrograph showing a modified layer formed by the wafer manufacturing method according to an embodiment of the present disclosure.

Fig. 7F is an enlarged schematic diagram illustrating a modified layer formed by the wafer manufacturing method according to an embodiment of the present disclosure.

Fig. 8 is an enlarged plan view illustrating an example of a two-dimensional scanning pattern of the laser beam in the laser machining method and the wafer manufacturing method according to an embodiment of the present disclosure.

Fig. 9 is an enlarged plan view illustrating another example of the two-dimensional scanning pattern of the laser beam in the laser machining method and the wafer manufacturing method.

Fig. 10 is an enlarged plan view illustrating still another example of the two-dimensional scanning pattern of the laser beam in the laser machining method and the wafer manufacturing method.

Fig. 11 is a flowchart illustrating an outline of a wafer manufacturing method according to another embodiment of the present disclosure.

Fig. 12 is a plan view illustrating an example of a setting pattern of a measurement position during a wafer optical measurement step illustrated in Fig. 11.

Fig. 13 is a plan view illustrating a scanning manner of the measurement position during the wafer optical measurement step illustrated in Fig. 11.

Fig. 14 is a graph illustrating a manner of change in an absorption coefficient, which is calculated from transmittance measured at the measurement position illustrated in Fig. 13, depending on the measurement position.

Fig. 15A is a lateral cross-sectional view illustrating a difference in the position of modified-layer generation during the laser slicing step illustrated in Fig. 11, that is, the separation-layer formation step, depending on transmittance.

Fig. 15B is a lateral cross-sectional view illustrating a difference in the position of modified-layer generation during the laser slicing step illustrated in Fig. 11, that is, the separation-layer formation step, depending on transmittance.

Fig. 15C is a lateral cross-sectional view illustrating a difference in the position of modified-layer generation during the laser slicing step illustrated in Fig. 11, that is, the separation-layer formation step, depending on transmittance.

Fig. 16 is a lateral cross-sectional view for explaining an example of an approach to setting laser beam irradiation conditions for the laser slicing step illustrated in Fig. 11, that is, the separation-layer formation step.

Fig. 17 is a plan view for explaining a method of deriving an amount of change in the absorption coefficient illustrated in Expression (2).

Fig. 18A is a graph illustrating a manner of change in an absorption coefficient in a depth direction of the ingot at an in-plane center position illustrated in Fig. 17.

Fig. 18B is a graph illustrating a manner of change in an absorption coefficient in the depth direction of the ingot at a first peripheral position illustrated in Fig. 17.

Fig. 18C is a graph illustrating a manner of change in an absorption coefficient in the depth direction of the ingot at a second peripheral position illustrated in Fig. 17.

Fig. 19 is a graph for explaining an example of a method of deriving the absorption coefficient.

Fig. 20 is a side view illustrating a first generated body and a second generated body, which are generated for setting the laser beam irradiation conditions for the laser slicing step illustrated in Fig. 11, that is, the separation-layer formation step.

Fig. 21 is a graph illustrating a region where a measurement pitch for the wafer optical measurement step illustrated in Fig. 11 is made finer.

Fig. 22 is a diagram illustrating a formation status of an irradiation mark in the laser machining method and the wafer manufacturing method according to still another embodiment of the present disclosure.

Fig. 23 is an enlarged plan view illustrating a modification example of a two-dimensional irradiation and scanning pattern of a laser beam illustrated in Fig. 10.

Fig. 24 is a diagram illustrating a formation status of an irradiation mark in a case where a beam shape of the laser beam is an annular shape as illustrated in Fig. 3.

Fig. 25 is a diagram illustrating a formation status of an irradiation mark in a case where a laser beam having a beam shape different from the beam shape illustrated in Fig. 24.

Fig. 26 is a diagram illustrating an example of an energy distribution in a beam radial direction of the annular laser beam illustrated in Fig. 24.

Fig. 27 is a diagram illustrating another example of the energy distribution in the beam radial direction of the annular laser beam illustrated in Fig. 24.

Fig. 28 is a diagram illustrating a formation status of an irradiation mark in a laser machining method and a wafer manufacturing method according to a modification example.

[Description of Embodiments]

(Embodiments)

Description will be given below on embodiments of the present disclosure with reference to the drawings. It should be noted that insertion of a variety of modification examples applicable to an embodiment into the middle of a series of descriptions about the embodiment could hinder the understanding of the embodiment. Accordingly, the modification examples are not inserted into the middle of the series of descriptions about the embodiment but collectively described later.

(Structures of Wafer and Ingot)

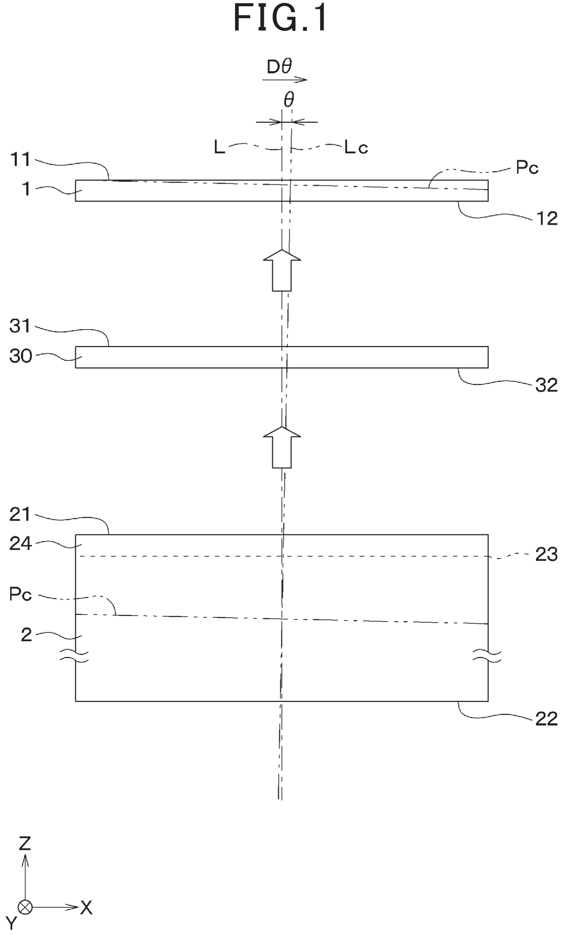

Referring to Fig. 1, a wafer 1 manufactured by a wafer manufacturing method according to the present embodiment is obtainable by slicing an ingot 2, which is substantially in a columnar shape in side view, along a plane substantially orthogonal to a height direction and is in the form of a thin plate substantially in a circular shape in plan view. It should be noted that the illustration and description of a so-called orientation flat, which is usually provided in the wafer 1 and the ingot 2, are omitted, if necessary, for the sake of simplicity in illustration and description.

Fig. 1 illustrates the wafer 1 and the ingot 2 in a state of being coaxially placed along a center axis L parallel to a thickness direction of the wafer 1 and a height direction of the ingot 2 for the convenience of description. That is to say, the wafer 1 has a peripheral surface substantially in the form of a cylindrical surface surrounding the center axis L. Likewise, the ingot 2 has a side surface substantially in the form of a cylindrical surface surrounding the center axis L. The center axis L is parallel to the side surface or the peripheral surface, which is substantially in the form of a cylindrical surface, of the wafer 1 or the ingot 2 and is also an imaginary straight line passing through an axial center of the wafer 1 or the ingot 2.

In the present embodiment, the ingot 2 is a single crystal SiC ingot having a c-axis $L_c$ and a (0001) plane $P_c$, which are orthogonal to each other, and has an off-angle $\theta$ exceeding zero degrees. The c-axis $L_c$ is a crystal axis represented by a direction index [0001]. The (0001) plane $P_c$ is a crystal plane orthogonal to the c-axis $L_c$ and that is referred to as "C-plane" in the strict crystallographic sense. The off-angle $\theta$ is an angle made by the center axis L of the wafer 1 or the ingot 2 and the c-axis $L_c$ and is, for example, in a range from one to four degrees, approximately. That is to say, the c-axis $L_c$ of the wafer 1 and the ingot 2 is provided in a state where the center axis L is inclined in an off-angle direction $D\theta$ by the off-angle $\theta$ exceeding zero degrees. The off-angle direction $D\theta$ is a direction obtained by mapping, onto the laser irradiation surface, a movement direction of a point on the center axis L located on a laser irradiation surface side in a case where the center axis L is rotated toward the c-axis $L_c$ around an intersection between the center axis L and the c-axis $L_c$. The laser irradiation surface is an upper surface or a top surface of the wafer 1 or the ingot 2 in the figure.

For the sake of simplicity in description, a right-handed coordinate system is set as illustrated in Fig. 1. In the right-handed XYZ coordinate system, the off-angle direction $D\theta$ and a positive X-axis direction are deemed to be the same. The X-axis and the Y-axis are deemed to be parallel to principal surfaces of the wafer 1 and the ingot 2. The "principal surface" may be a surface orthogonal to a thickness direction of a plate-shaped object and may also be referred to as "upper surface", "bottom surface", or "plate surface." Alternatively, the "principal surface" may be a surface orthogonal to a height direction of a pillar-shaped object such as the ingot 2 and may also be referred to as "top surface" or "bottom surface". Further, the thickness direction of the wafer 1 and the height direction of the ingot 2 are deemed to be parallel to the Z-axis. Hereinbelow, any direction orthogonal to the Z-axis is occasionally referred to as "in-plane direction".

The wafer 1 has a pair of principal surfaces, a wafer C-plane 11 and a wafer Si-plane 12. In the present embodiment, the wafer 1 is formed such that the wafer C-plane 11, which is an upper surface thereof, is inclined by the off-angle $\theta$ with respect to the (0001) plane $P_c$. Likewise, the ingot 2 has a pair of principal surfaces, an ingot C-plane 21 and an ingot Si-plane 22. The ingot 2 is formed such that the ingot C-plane 21, which is a top surface, is inclined by the off-angle $\theta$ with respect to the (0001) plane $P_c$. It should be noted that a direction where the wafer C-plane 11 and the ingot C-plane 21 face is shown as a positive Z-axis direction in Fig. 1.

(Outline of Wafer Manufacturing Method)

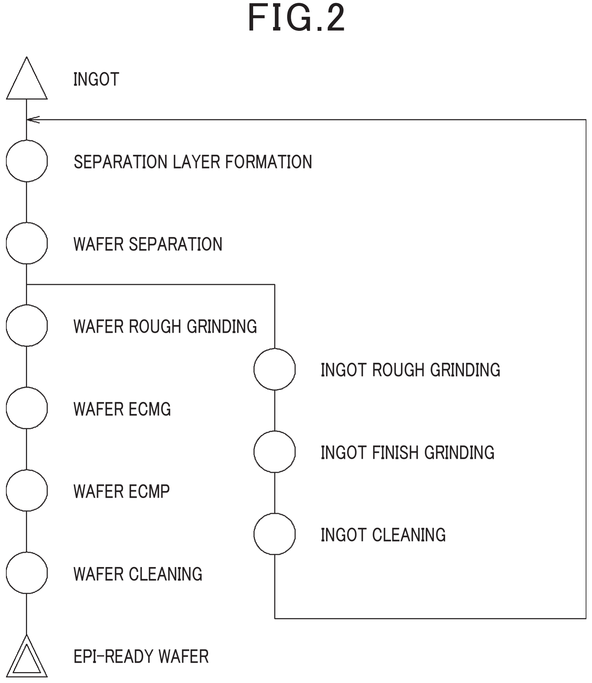

A wafer manufacturing method according to the present embodiment is a method in which laser machining is used to obtain the wafer 1 from the ingot 2. Fig. 2 is a flowchart illustrating a typical example exemplifying the wafer manufacturing method according to the present embodiment. Description will be made below on the outline of each step of the wafer manufacturing method. It should be noted that the term "step" may also be referred to as "procedure" or "process." Moreover, the term "step" does not merely indicate an independent step but includes even a case where a clear distinction from another step is difficult or impossible insofar as a desired object of that step is achieved. The same applies to the term "process" or "procedure."

(1) Separation-layer formation step

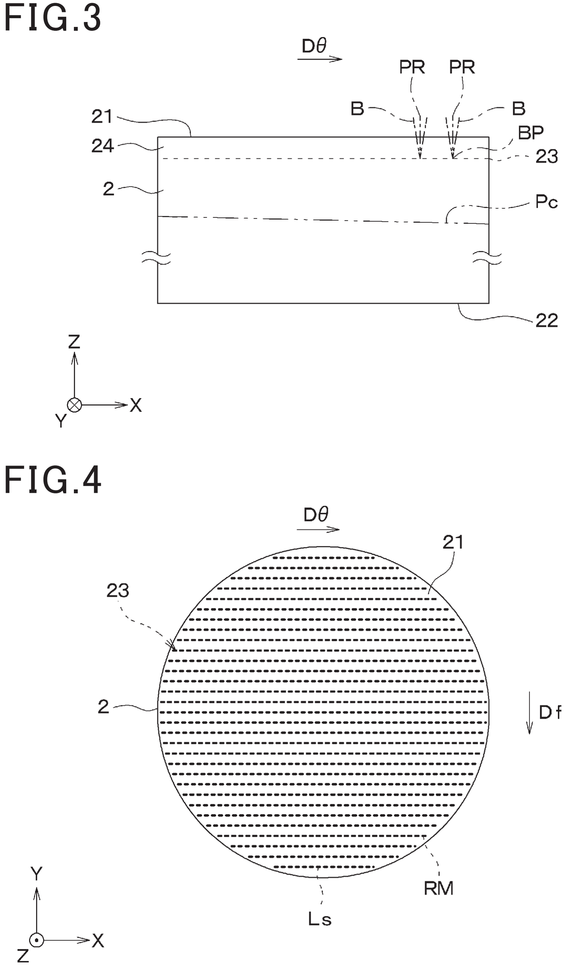

As illustrated in Fig. 3, the ingot C-plane 21, which is a principal surface on one end side in the height direction of the ingot 2, is irradiated with a laser beam B having a predetermined degree of transmittance through the ingot 2. This forms a separation layer 23 at a depth corresponding to a thickness of the wafer 1 from the ingot C-plane 21. Here, the "predetermined degree of transmittance" is a transmittance that allows a focal point BP of the laser beam B to be formed inside the ingot 2 at the depth corresponding to the thickness of the wafer 1. The "depth corresponding to the thickness of the wafer 1" refers to a dimension given by adding a thickness equivalent of a predetermined machining allowance for a later-described wafer planarization step or the like to a target value of the thickness of the wafer 1 as a finished product and may also be referred to as "depth equivalent of the thickness of the wafer 1."

(2) Wafer separation step

A wafer precursor 24, which is a portion between the laser irradiation surface, or ingot C-plane 21, and the separation layer 23, is separated from the ingot 2 at the separation layer 23. Here, as seen from the above expression "wafer separation step", a plate-shaped object obtained by separating the wafer precursor 24 from the ingot 2 may be referred to as "wafer" under normal social conventions. However, for distinction from the wafer 1 as a finished product having a principal surface mirror-polished to be epi-ready, the plate-shaped object is referred to as "separated body 30" hereinbelow.

The separated body 30 has a pair of principal surfaces, a non-separation surface 31 and a separation surface 32. The non-separation surface 31 is a surface on a side where no separation layer 23 is provided before the wafer separation step and also a surface corresponding to the ingot C-plane 21 before the separation-layer formation step and the wafer separation step are performed. The separation surface 32, which provides the separation layer 23 before the wafer separation step, is a surface newly formed through the wafer separation step. The separation surface 32 has unevenness with some roughness attributed to a variation in a formation depth of the separation layer 23 or separation during the wafer separation step and that requires grinding or polishing.

(3) Wafer Planarization Step

The wafer 1 as a finished product is obtained by planarizing, out of the non-separation surface 31 and the separation surface 32 as the principal surfaces of the separated body 30, at least the separation surface 32. For the wafer planarization step, ECMG and ECMP are usable in addition to usual polishing with a whetstone and CMP. It should be noted that CMP is an abbreviation of Chemical Mechanical Polishing. ECMG is an abbreviation of Electro-Chemical Mechanical Grinding. ECMP is an abbreviation of Electro-Chemical Mechanical Polishing. The above plurality of types of planarization steps may be used alone or used in combination, if necessary, to perform the wafer planarization step.

(4) Ingot Planarization Step

An upper surface of the ingot 2 newly formed by separating the wafer precursor 24 at the separation layer 23 is planarized, that is, mirror-finished, so that it is able to be provided again to the separation-layer formation step. For the ingot planarization step, ECMG and ECMP are also usable in addition to usual polishing with a whetstone and CMP. The above plurality of types of planarization steps may also be used alone or used in combination, if necessary, to perform the ingot planarization step.

As illustrated in Fig. 2, the separated body 30 separated from the ingot 2 through the separation-layer formation step and the wafer separation step is finished as the epi-ready wafer 1 through the following steps.

- Rough grinding of the separation surface 32, which is to become the wafer Si-plane 12
- ECMG grinding of the roughly ground separation surface 32
- ECMP polishing of the ECMG-ground separation surface 32
- Cleaning

Moreover, the ingot 2 remaining after the separated body 30 is separated from the ingot 2 through the separation-layer formation step and the wafer separation step may be provided again to the separation-layer formation step through the following steps.

- Rough grinding of the ingot C-plane 21 newly formed by the wafer separation step
- Finish grinding of the roughly ground ingot C-plane 21
- Cleaning

(Details of Separation-layer formation step)

Description will be given below on the details of the separation-layer formation step corresponding to the laser machining method of the present disclosure with reference to Fig. 3 and the like in addition to Fig. 1 and Fig. 2. It should be noted that the right-handed XYZ coordinate system illustrated in Fig. 3 and the like are deemed to be set such that it coincides with the right-handed XYZ coordinate system illustrated in Fig. 1. As illustrated in Fig. 3, the separation-layer formation step is a step in which the separation layer 23 is formed inside the ingot 2 by irradiation with the laser beam B having a transmittance through the ingot 2, which is a machining target made of a semiconductor material.

In the present embodiment, a laser scan parallel to the off-angle direction Dθ is performed for a plurality of times with changes in position in a line feed direction Df as illustrated in Fig. 4 during the separation-layer formation step. The laser scan is deemed to refer to irradiating the ingot C-plane 21 with the laser beam B while moving an irradiation position PR in the ingot C-plane 21, which is the laser irradiation surface, along the off-angle direction Dθ along the ingot C-plane 21. Accordingly, the laser scan refers to irradiating the ingot C-plane 21 across the full width in the off-angle direction Dθ with the laser beam B. Here, the "irradiation position PR" is deemed to refer to a center position of the laser beam B in the ingot C-plane 21. It should be noted that the "irradiation position PR" is deemed to include not only, within the ingot C-plane 21, a position actually irradiated with the laser beam B but also a position planned to be irradiated and a position irradiated in the past with the laser beam B. Moreover, in the present embodiment, an irradiation mark RM is formed at each of a plurality of irradiation positions PR during a single laser scan by intermittently performing irradiation with the pulsed laser beam B at the discrete irradiation positions PR while relatively moving the laser beam B along the off-angle direction Dθ with respect to the ingot 2. Accordingly, the "moving the irradiation position PR" is deemed to refer to almost discontinuously or discretely moving, the position of the laser beam B, which is intermittently applied within the ingot C-plane 21. The line feed direction Df, which is a direction orthogonal to the off-angle direction Dθ and along the ingot C-plane 21, is equivalent of a second direction of the present disclosure.

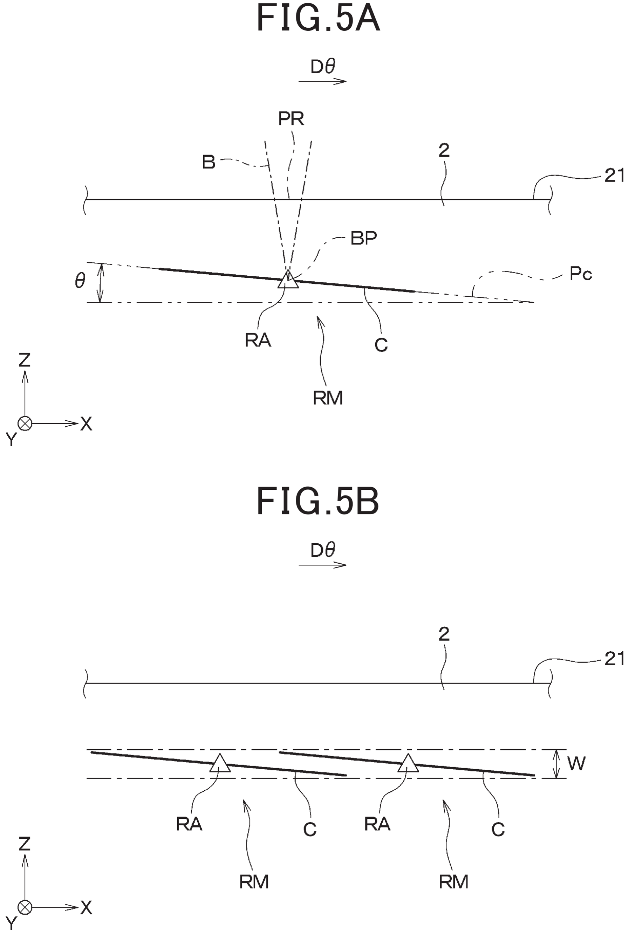

The separation layer 23 is formed by forming, in the line feed direction Df, a plurality of irradiation trajectory lines Ls, each consisting of the irradiation marks RM of the laser beam B arrayed in a linear dotted line parallel to the off-angle direction Dθ as illustrated in Fig. 4. That is to say, the irradiation trajectory lines Ls are the arrays of the irradiation marks RM in a linear dotted line and that are formed by the respective single laser scans. A spacing in the line feed direction Df between adjacent ones of the irradiation trajectory lines Ls on the separation layer 23 is referred to as "line pitch" hereinbelow. The line pitch is larger than an irradiation pitch. The irradiation pitch is a spacing between adjacent ones of the irradiation marks RM contained in one irradiation trajectory line Ls. The irradiation marks RM are formed of a modified layer RA and a crack C as illustrated in Fig. 5A and the like. The modified layer RA is a modified region formed by decomposing SiC into silicon and carbon through irradiation with the laser beam B. Accordingly, the separation-layer formation step may also be referred to as a modified-layer formation step. With the formation of the modified layer RA, the crack C originates at the modified layer RA, developing along the (0001) plane Pc. That is to say, a development direction of the crack C is inclined by the off-angle θ with respect to the in-plane direction parallel to the ingot C-plane 21 as illustrated in Fig. 5A.

The laser beam B has the predetermined degree of transmittance through the ingot 2 as described above. Thus, the focal point BP is formed at the position at a predetermined depth from the ingot C-plane 21, which is the laser irradiation surface. Consequently, the modified layer RA is formed at the position at the predetermined depth from the ingot C-plane 21 corresponding to the focal point BP. The separation layer 23 is formed at the position at the predetermined depth from the ingot C-plane 21 by performing a laser scan almost across the full width of the ingot 2 in the line feed direction Df to form the plurality of irradiation trajectory lines Ls along the line feed direction Df. The wafer precursor 24, which is to become the wafer 1, is thus formed on the side of the ingot C-plane 21 with respect to the separation layer 23.

Fig. 5A and Fig. 5B illustrate the manner of formation of the irradiation mark RM by a wafer manufacturing method of Comparative Example 1, which is equivalent of a technology disclosed in JP 2016-111143 A. Comparative Example 1 is an example where a laser scan is performed not in the off-angle direction Dθ but in the in-plane direction orthogonal thereto, that is, in the line feed direction Df in Fig. 4. According to Comparative Example 1, the crack C considerably develops in the off-angle direction Dθ between adjacent laser scans in the off-angle direction Dθ. Then, a machining allowance region W, which is a width in a depth direction of the irradiation mark RM, increases as illustrated in Fig. 5B. The machining allowance region W, which is equivalent of a thickness of the separation layer 23 illustrated in Fig. 3, defines a machining allowance for the wafer planarization step or the ingot planarization step after the wafer separation step. That is to say, a portion of the material to be removed and wasted from the separated body 30 or the ingot 2 by grinding or polishing during the wafer planarization step or the ingot planarization step is at least equal to or more than machining allowance region W. Consequently, a considerable material loss occurs in Comparative Example 1.

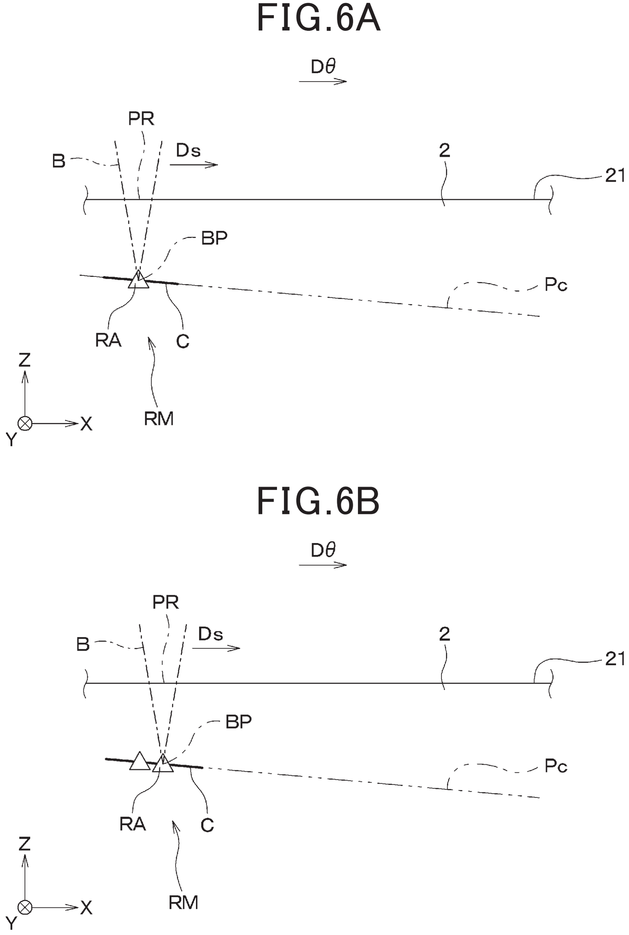

In contrast, Fig. 6A to Fig. 6D illustrate the manner of formation of the irradiation mark RM according to Comparative Example 2, in which, to address the above problem, merely the direction of a laser scan is changed to a direction parallel to the off-angle direction Dθ. By performing a laser scan in a scanning direction Ds parallel to the off-angle direction Dθ, the next irradiation mark RM is formed before a development amount in the off-angle direction Dθ of the crack C of the irradiation mark RM formed earlier sufficiently increases as illustrated in Fig. 6A and Fig. 6B. That is to say, the development of the crack C of the irradiation mark RM formed earlier is reduced by the subsequently formed irradiation mark RM. This may further reduce the development amount of the crack C in the off-angle direction Dθ of each of the plurality of irradiation marks RM arrayed in the scanning direction Ds as compared to the case in Fig. 5A and Fig. 5B.

Here, a situation in which no irradiation mark RM exists around the irradiation position PR in the in-plane direction is assumed. In such a situation, the irradiation mark RM is likely to be generated at a depth near the focal point BP under the irradiation with the laser beam B. However, the laser beam B actually moves in the scanning direction Ds while generating the irradiation marks RM in succession. Thus, the situation as described above occurs mainly when the irradiation mark RM corresponding to a starting point of the irradiation trajectory line Ls first formed by a single laser scan. Therefore, a situation in which the irradiation mark RM exists around the irradiation position PR in the in-plane direction occurs in the majority of scenes during the laser scan.

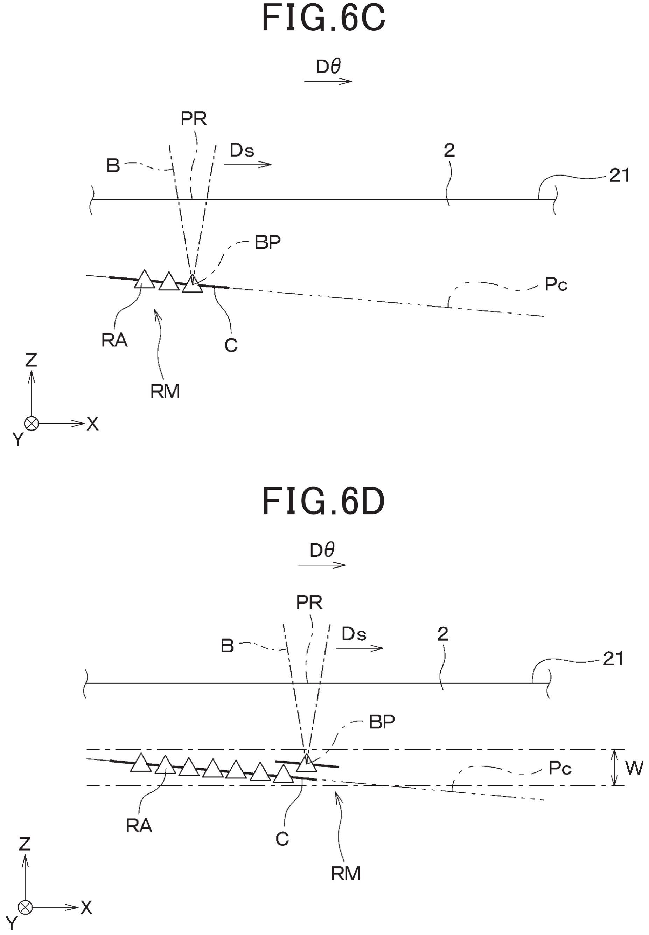

That is to say, at least the crack C of the irradiation mark RM formed earlier usually exists in an in-plane position corresponding to the current irradiation position PR as illustrated in Fig. 6B and Fig. 6C. Then, an absorption rate of the laser beam B is enhanced at that irradiation mark RM. Moreover, the crack C is formed along the (0001) plane Pc. This facilitates the development of the generation positions of the modified layer RA and the irradiation mark RM along the (0001) plane Pc during the laser scan, as illustrated in Fig. 6C.

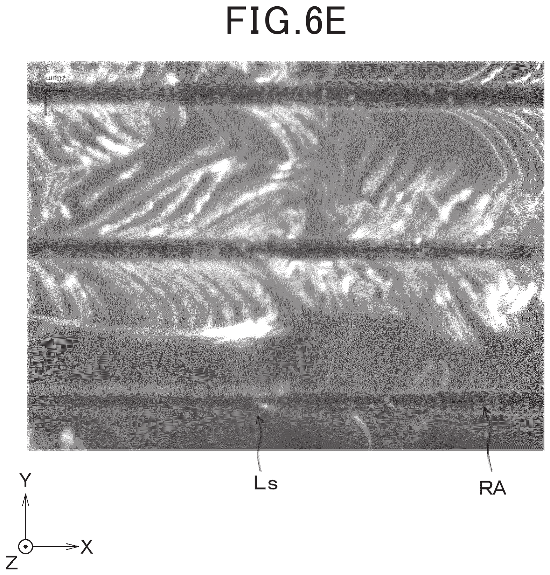

With development in the scanning direction Ds along the (0001) plane Pc, the position where the irradiation mark RM is formed becomes gradually deeper, thus gradually deviating from the original depth of the focal point BP. Then, a situation arises where an application density of an energy resulting from the currently applied laser beam B fails to be increased to a level allowing for the generation of a new modified layer RA at a depth equivalent of the irradiation mark RM formed immediately before. As such a situation arises, the new modified layer RA is formed at a depth near the focal point BP of the currently applied laser beam B as illustrated in Fig. 6D. A step is thus generated between the irradiation mark RM formed immediately before and the irradiation mark RM currently formed. This results in an increase in the machining allowance region W, which is a width in the depth direction of the irradiation mark RM. Therefore, Comparative Example 2 also suffers from the occurrence of a considerable material loss. Fig. 6E is a close-up optical micrograph showing the irradiation trajectory line Ls in Comparative Example 2. As shown in Fig. 6E, in the irradiation trajectory line Ls in Comparative Example 2, a region where the modified layer RA is in focus and a region where the modified layer RA is not in focus are formed depending on a variation in a formation depth of the modified layer RA as described above in the X-axis direction, that is, the scanning direction Ds.

Accordingly, in the present embodiment, a linear, that is, one-dimensional, direction of a laser scan, that is, a travel direction of the laser beam B or the irradiation position PR, is set parallel to the off-angle direction Dθ, and the irradiation position PR of the laser beam B in the travel direction is made multiple points. That is to say, a plurality of laser beams B spaced from each other in the travel direction are simultaneously applicable and scanned in a direction parallel to the off-angle direction Dθ. Then, the irradiation mark RM formed by irradiation with the laser beam B that precedes in the travel direction is irradiated with the laser beam B that follows. Specifically, a small modified layer RA is formed with the laser beam B that precedes, and the modified layer RA is irradiated with the laser beam B that follows to enlarge the modified layer RA.

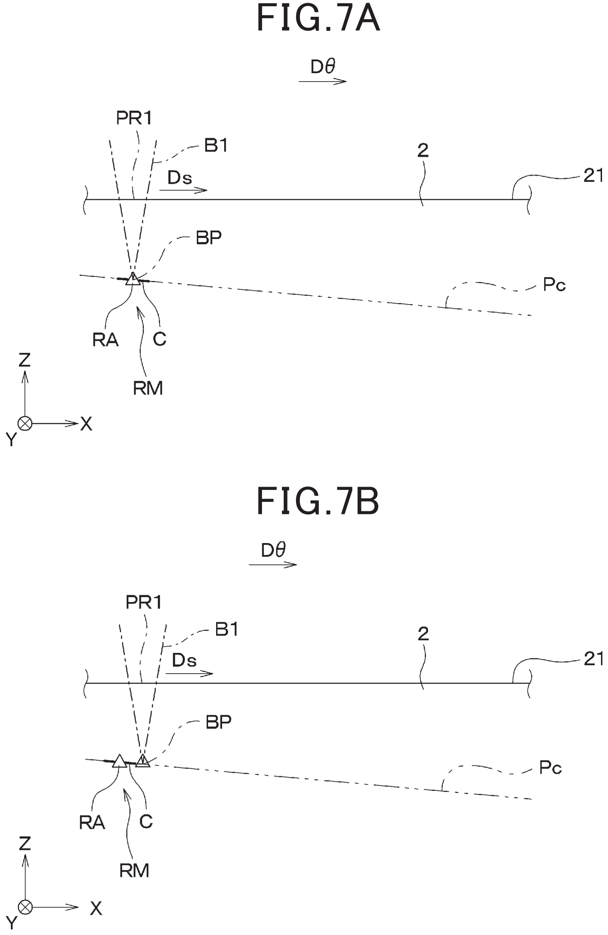

The laser scan in the present embodiment will be described below in further detail with reference to Fig. 7A to Fig. 7D. In these figures, the travel direction is represented as the scanning direction Ds. Moreover, the laser beam B that precedes in the scanning direction Ds is referred to as a preceding beam B1 and the laser beam B that follows is referred to as a following beam B2. A spacing in the scanning direction Ds between the preceding beam B1 and the following beam B2 may be N-times the irradiation pitch. N is a positive integer and N ≥ 2. Moreover, the irradiation position PR corresponding to the preceding beam B1 is referred to as a preceding irradiation position PR1 and the irradiation position PR corresponding to the following beam B2 is referred to as a following irradiation position PR2.

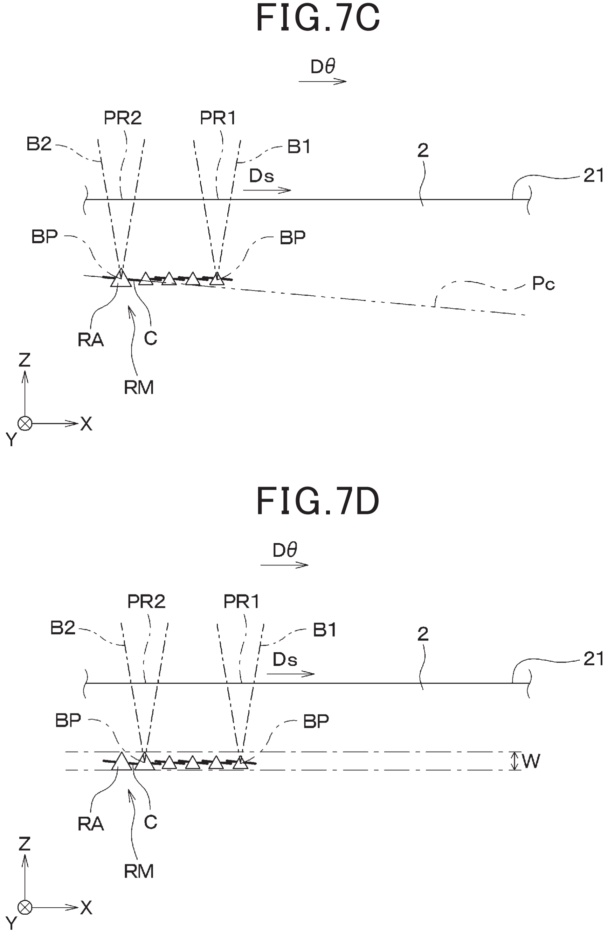

First, the irradiation mark RM is formed at a position corresponding to the preceding irradiation position PR1 using the preceding beam B1 as illustrated in Fig. 7A. The preceding beam B1 is outputted with an energy, that is, a pulse energy, lower than that in a case where a single irradiation with the laser beam B is performed with respect to one irradiation position PR as in the comparative examples. It should be noted that the "single irradiation" in this case may include a number of pulsed irradiations. As seen from the above, the modified layer RA formed by irradiation with the preceding beam B1 with a relatively low energy and a development amount of the crack C from that modified layer RA are smaller than those in the comparative examples. Thus, it is possible to form the focal point BP of the next preceding beam B1 at a position where the irradiation mark RM formed immediately before does not interfere as illustrated in Fig. 7B. This makes it possible to form the modified layer RA formed using the preceding beam B1 at substantially the same depth. Therefore, a large number of modified layers RA formed using the preceding beam B1 develop not along the (0001) plane Pc but along the same plane substantially parallel to the ingot C-plane 21 as illustrated in Fig. 7B and Fig. 7C.

The modified layer RA formed by irradiation with the preceding beam B1 is irradiated with the following beam B2 as illustrated in Fig. 7C. This enlarges the modified layer RA and also causes the crack C to develop in the line feed direction Df. Similarly to the preceding beam B1, the following beam B2 is also outputted with an energy lower than that in a case where a single irradiation with the laser beam B is performed with respect to one irradiation position PR as in the comparative examples. The output energy of the preceding beam B1 and the output energy of the following beam B2 may be the same or different. Specifically, for example, the output energies of the preceding beam B1 and the following beam B2 are adjustable in accordance with the transmittance of the laser beam B through the ingot 2, or the like, if necessary.

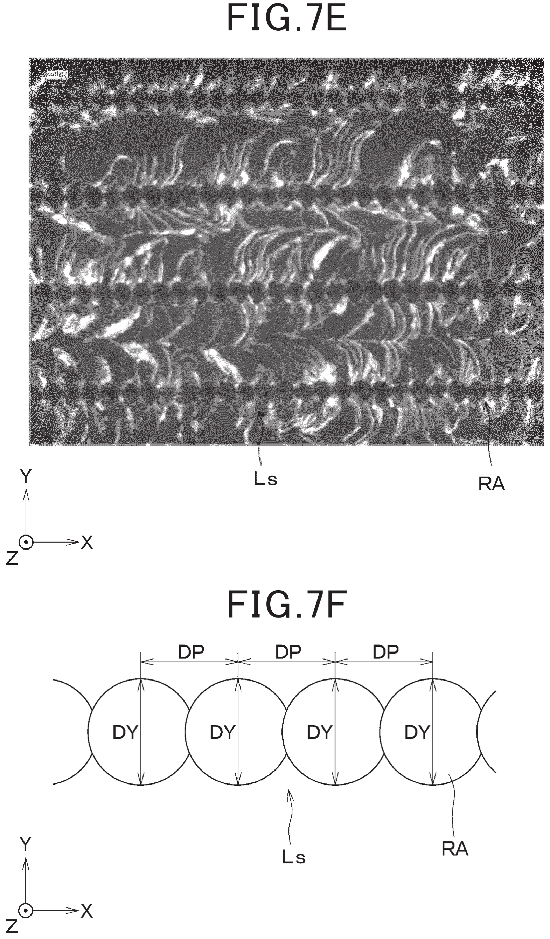

According to the present embodiment, a plurality of modified layers RA formed in array at substantially the same depth using the preceding beam B1 are sequentially irradiated with the following beam B2, causing the irradiation mark RM to develop along the same plane substantially parallel to the ingot C-plane 21, as illustrated in Fig. 7D. This favorably reduces a variation in the formation depth of the modified layer RA and the irradiation mark RM. That is to say, it is possible to form the separation layer 23 as thin as possible. Fig. 7E is a close-up optical micrograph showing the irradiation trajectory line Ls in the present embodiment. As shown in Fig. 7E, in the irradiation trajectory line Ls in the present embodiment, the modified layer RA is in focus as a whole irrespective of the position in the X-axis direction, that is, the scanning direction Ds. Thus, the machining allowance region W, which becomes material loss, may be favorably reduced and a process time may be reduced as much as possible. Therefore, according to the present embodiment, it is possible to provide a wafer manufacturing method exhibiting a higher manufacturing efficiency than a conventional method. Fig. 7F is an enlarged schematic diagram of the irradiation trajectory line Ls of the present embodiment. In Fig. 7F, a local maximum value of a width in the Y-axis direction, that is, the line feed direction Df, of the modified layer RA is referred to as a local maximum width DY. Moreover, a spacing in the X-axis direction, that is, the scanning direction Ds, between adjacent ones of the modified layers RA at a position corresponding to the local maximum width of the modified layer RA is referred to as a local maximum spacing DP. Then, an average value of the local maximum width DY is denoted by DYave and an average of the local maximum spacing DP is denoted by DPave. In this case, according to the present embodiment, the irradiation trajectory line Ls, that is, the separation layer 23, can be formed by the laser scan such that $DYave/DPave \leq 5$. Moreover, it is preferable that $DYave/DPave \leq 2$. Further, it is preferable that the laser scan be performed such that

$DYave/DPave$ is within a range from 0.7 to 1.3, approximately, as in an example in Fig. 7E.

(Line Feed Pattern)

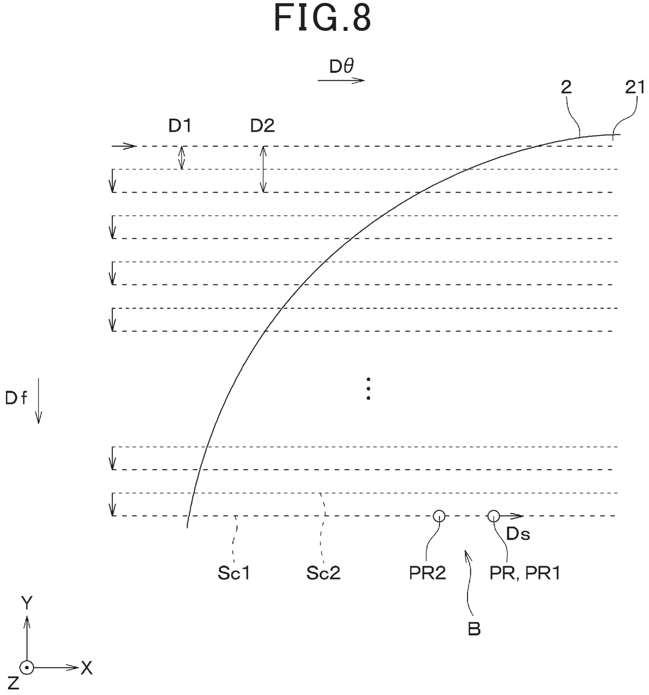

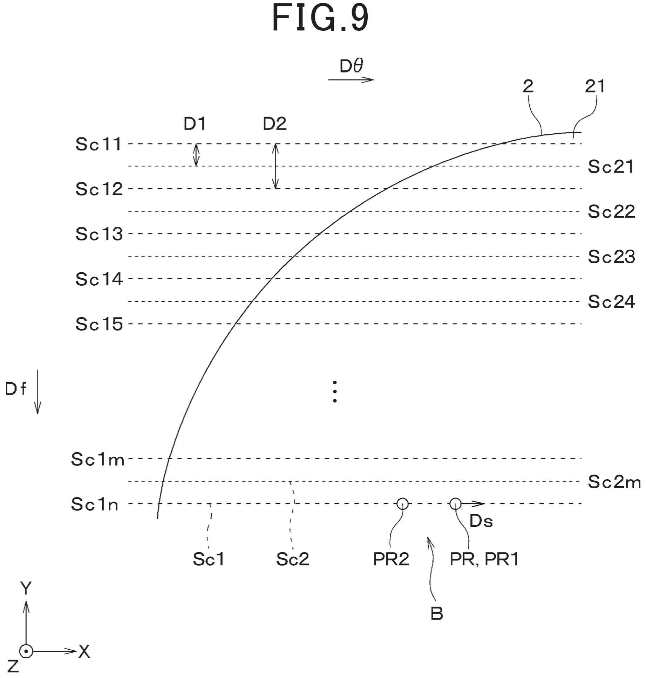

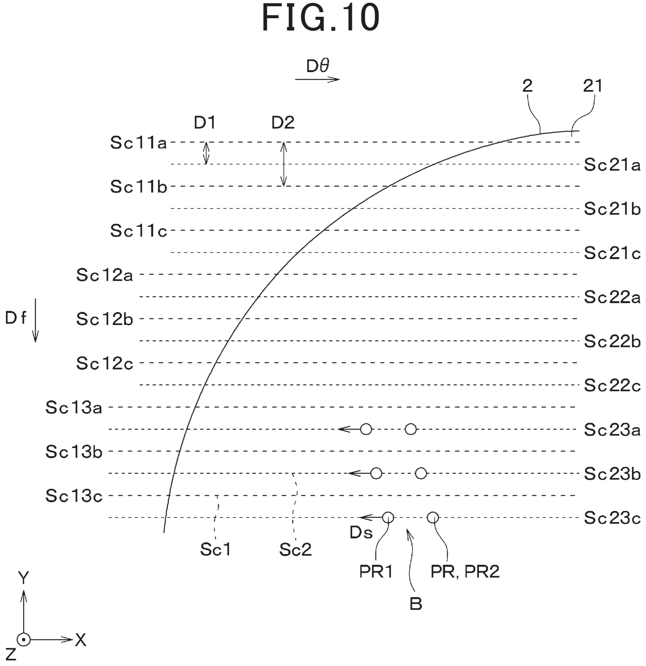

Fig. 8 illustrates an example of a two-dimensional scanning pattern of the laser beam B. In Fig. 8, trajectories or planned trajectories of the laser beam B or the irradiation position PR are represented as a first scanning line Sc1 and a second scanning line Sc2. The first scanning line Sc1 and the second scanning line Sc2 are both parallel to the off-angle direction Dθ. The first scanning line Sc1 and the second scanning line Sc2 are alternately and equidistantly arrayed in the line feed direction Df. A spacing D1 between adjacent ones of the first scanning lines Sc1 and second scanning lines Sc2 in the line feed direction Df is the same as the line pitch. A spacing D2 between adjacent two of the first scanning lines Sc1 in the line feed direction Df is twice the line pitch. Likewise, a spacing D2 between adjacent two of the second scanning lines Sc2 in the line feed direction Df is twice the line pitch. A scan with the laser beam B on the first scanning line Sc1 is referred to as first laser scan. Likewise, a scan with the laser beam B on the second scanning line Sc2 is referred to as second laser scan. The same applies to examples of the scanning pattern illustrated in later-described Fig. 9 and Fig. 10.

In the scanning pattern illustrated in Fig. 8, a direction of relative movement between the laser beam B and the ingot 2 is reversed between a single laser scan and the next single laser scan. That is to say, in the present scanning mode, the scanning direction Ds, which is a movement direction of the irradiation position PR during the first laser scan, is the same as the off-angle direction Dθ, and the scanning direction Ds during the second laser scan is the opposite direction to the off-angle direction Dθ. Then, the first laser scan and the second laser scan, the scanning directions Ds of which are reversed from each other, are alternately performed. In other words, the laser scan is performed in a zig-zag manner. The scanning direction Ds corresponds to a first direction of the present disclosure.

Meanwhile, with irradiation with the laser beam B, the crack C develops along the (0001) plane Pc as described above. Here, development in the off-angle direction Dθ may be approximately restricted to the irradiation pitch by forming the modified layer RA using the preceding beam B1 prior to irradiation with the following beam B2. In contrast, development in the line feed direction Df is not particularly restricted unless the preceding irradiation trajectory line Ls is formed. Thus, in the scanning pattern illustrated in Fig. 8, a situation where the crack C extending from the previously formed irradiation trajectory line Ls reaches the current irradiation position PR may occur especially in a case where a small line pitch is desired to be set. If such a situation arises, a region where the crack C exists will be irradiated with the laser beam B, which may result in a variation in the formation depth of the modified layer RA due to an enhanced absorption rate at a location where the crack C is generated as described above. Alternatively, the crack C reflects the laser beam B to cause the focal point BP to occur at a position shallower than a planned depth, which may result in the generation of the modified layer RA to occur at a shallower position than usual. Therefore, when the situation as described above occurs, there is a concern that the machining allowance region W increases, leading to greater material loss.

Accordingly, in the scanning pattern illustrated in Fig. 9, the second laser scan is performed between the irradiation trajectory lines Ls formed by the first laser scans along adjacent ones of the first scanning lines Sc1 in the line feed direction Df. Specifically, numbers such as Sc11, Sc12, Sc13,...Sc1m, and Sc1n are assigned to a plurality of first scanning lines Sc1 in order from top in the figure as illustrated in Fig. 9. m and n are integers of one or more that indicate ordinal numbers and, for simplicity of illustration, n = m + 1. Likewise, numbers such as Sc21, Sc22, Sc23,...Sc2m are assigned to a plurality of second scanning lines Sc2 in order from top in the figure. Then, in the present scanning pattern, after the m-th first laser scan and the next n-th first laser scan are performed, the m-th second laser scan is performed. As seen from the above, in the present scanning pattern, the second laser scan is performed between irradiation trajectory lines Ls that are adjacent in the line feed direction Df and formed by the first laser scans performed at a pitch twice the line pitch in the line feed direction Df.

According to such a scanning pattern, a situation may be easily achieved where in performing the first laser scan, no crack C extending from the irradiation trajectory line Ls formed earlier reaches the first scanning line Sc1 corresponding to that first laser scan. Thus, during the first laser scan, the laser beam B suffers no interference of the crack C, so that the modified layer RA may be formed at a substantially uniform depth across the full width of the ingot 2 in the scanning direction Ds. Therefore, according to the present scanning pattern, material loss attributed to the occurrence of a variation in the formation depth of the modified layer RA may be favorably reduced.

It should be noted that the execution order of the plurality of first laser scans and the plurality of second laser scans is not particularly limited. That is to say, for example, the second laser scans may be performed after the first laser scans are performed for the full width of the ingot 2 in the line feed direction Df. That is to say, the first laser scans may be first completed and then the second laser scans may be performed. At this time, the scanning directions Ds of the plurality of first laser scans may be all the same or may be alternately set to be the same as the off-angle direction Dθ and the direction opposite thereto. The same applies to the scanning directions Ds of the plurality of second laser scans. Alternatively, for example, the second laser scans and the first laser scans may be alternately performed after the first and second first laser scans are performed, such as Sc11, Sc12, Sc21, Sc13, Sc22, Sc14, Sc23, etc.

(Simultaneous Multi-Point Irradiation in Line Feed Direction)

Fig. 10 illustrates a scanning pattern in which a plurality of irradiation trajectory lines Ls are simultaneously formed by irradiating the ingot C-plane 21 with a plurality of laser beams B different at least in position in the line feed direction Df during a single laser scan. Specifically, Fig. 10 illustrates an example where six laser beams B in total, two in the scanning direction Ds and three in the line feed direction Df, are scanned in the scanning direction Ds during a single laser scan. It should be noted that the positions in the scanning direction Ds of the three laser beams B or irradiation positions PR arrayed in the line feed direction Df may be set such that they are offset by increments of a predetermined amount as illustrated in Fig. 10 or may be the same. That is to say, the three laser beams B or irradiation positions PR arrayed in the line feed direction Df may be arrayed parallel to the line feed direction Df.

In the present specific example, a plurality of first scanning lines Sc1 arrayed in the line feed direction Df are divided into groups of three, in order from top in the figure, such as Sc11a, Sc11b, Sc11c, Sc12a, Sc12b, Sc12c, Sc13a, Sc13b, Sc13c... A plurality of second scanning lines Sc2 are likewise divided into groups of three in order from top in the figure, such as Sc21a, Sc21b, Sc21c, Sc22a, Sc22b, Sc22c, Sc23a, Sc23b, Sc23c... Then, the first laser scan is performed for each group of three first scanning lines Sc1 - for example, Sc11a, Sc11b, and Sc11c are simultaneously subjected to the first laser scan and, subsequently, the scanning lines Sc12a, Sc12b, Sc12c are simultaneously subjected to the first laser scan. After that, the second laser scan is likewise performed for each group of three second scanning lines Sc2. This makes it possible to achieve an effect similar to that of the scanning mode illustrated in Fig. 8 or Fig. 9 in a shorter cycle time.

(Second Embodiment)

Description will be given below on a second embodiment. It should be noted that in the description of the present embodiment, a difference from the above-described first embodiment will be mainly described. Moreover, parts that are the same as or equivalent of each other in the above-described first embodiment and the present embodiment are designated by the same reference numeral. Accordingly, for a component designated by the same reference numeral as in the above-described first embodiment in the following description of the present embodiment, the description in the above-described first embodiment may be incorporated by reference, if necessary, unless there is a technical inconsistency or a particular additional description. The same applies to a later-described third embodiment.

According to the present embodiment, irradiation conditions of the laser beam B are controlled based on a measurement result of the transmittance of the laser beam B through the semiconductor material providing the ingot 2 in the above-described first embodiment. Specifically, according to the present embodiment, optical properties, that is, transmittance and refractive index, of the obtained wafer 1 or the separated body 30 are measured at a plurality of positions in the scanning direction Ds and the line feed direction Df and irradiation conditions of the next laser beam B are controlled based on the measurement result. The irradiation conditions include, for example, an irradiation energy, an irradiation distance, and the like.

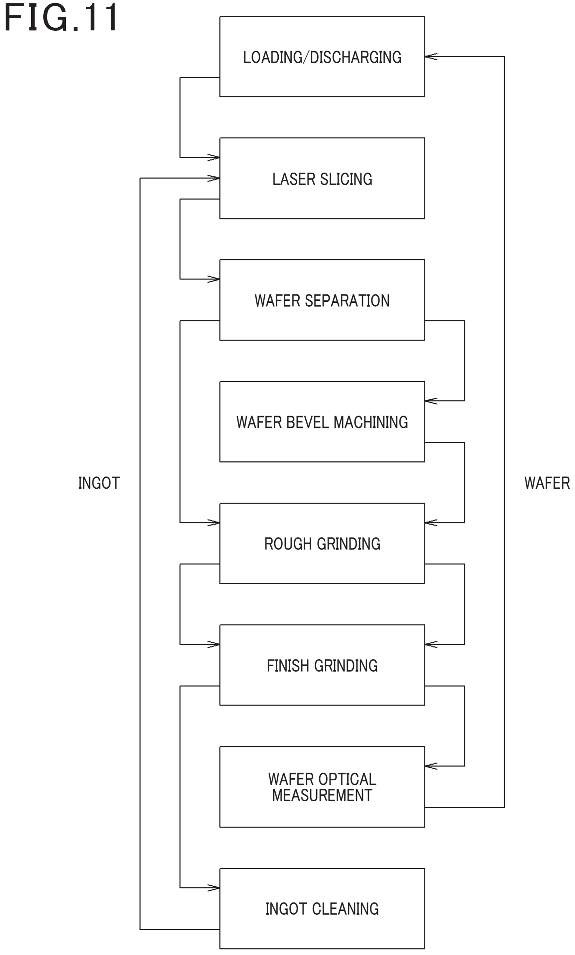

Fig. 11 illustrates an outline of a wafer manufacturing method according to the present embodiment. In Fig. 11, "LOADING/DISCHARGING" represents a step of loading and discharging the separated body 30, which is an object to be machined, or the ingot 2. "LASER SLICING" represents the separation-layer formation step. "ROUGH GRINDING" represents a step of roughly grinding a principal surface of the ingot 2 or the separated body 30. For the rough grinding, for example, an abrasive material with a grit size of #800, approximately, is usable. "FINISH GRINDING" represents a step of finish-grinding a surface. For the finish grinding, for example, an abrasive material with a grit size of #30000, approximately, is usable. "WAFER BEVEL MACHINING" represents machining for chambering a corner of an outer edge portion in a radial direction of the separated body 30. The "radial direction" herein refers to a direction radially extending from a center in an in-plane direction of the separated body 30 along the in-plane direction. "WAFER OPTICAL MEASUREMENT" represents a step of measuring the optical properties of the finish-ground separated body 30 at a plurality of positions in the scanning direction Ds and the line feed direction Df. "INGOT CLEANING" represents a step of cleaning the finish-ground ingot 2. Arrows on the left side of blocks representing the steps indicate a processing flow for the ingot 2. Arrows on the right side of the blocks representing the steps indicate a processing flow for the wafer 1 or for the separated body 30, which may be referred to as "wafer" under normal social conventions.

Referring to Fig. 11, the ingot 2 is first loaded in a wafer manufacturing device. Next, the separation-layer formation step based on laser slicing, that is, irradiation with the laser beam B, is applied to the loaded ingot 2. Subsequently, in the wafer separation step, the separated body 30 is separated from the ingot 2 subjected to the separation-layer formation step. An upper surface of the ingot 2, which is newly formed on the ingot 2 subjected to the wafer separation step, is planarized by rough grinding and finish grinding. After that, the ingot 2 is again subjected to the separation-layer formation step after being cleaned. It should be noted that the ingot 2 subjected to the separation-layer formation step or the ingot cleaning step is discharged from the wafer manufacturing device in a case where a height thereof is below a predetermined value.

The separated body 30 separated from the ingot 2 through the wafer separation step is subjected to bevel machining, rough grinding, and finish grinding and then subjected to optical measurement. A measurement result is provided for determination of the irradiation conditions of the laser beam B in the next separation-layer formation step. That is to say, based on the optical measurement result for each location in the in-plane direction of the wafer 1, the irradiation conditions for each location in the in-plane direction of the ingot C-plane 21 in the next separation-layer formation step are controlled. This makes it possible to finely change the irradiation conditions in accordance with a variation in optical properties depending on the locations in the in-plane direction and, consequently, reduce material loss. It should be noted that measuring either the transmittance or the refractive index alone is acceptable. Alternatively, measurement of the transmittance and the refractive index may be performed with respect to the finally obtained epi-ready wafer 1. Moreover, finish grinding may be unnecessary depending on rough grinding conditions. That is to say, rough grinding and finish grinding may be integrated.

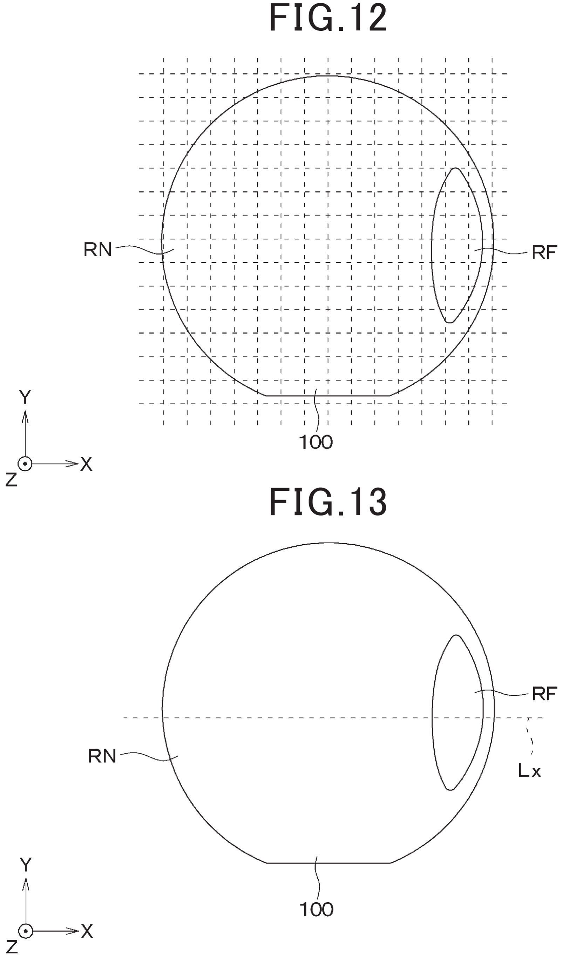

Fig. 12 illustrates an example of a setting pattern of an optical measurement position in a generated body 100. The generated body 100, which is an optical measurement target, is equivalent of the wafer 1, or the separated body 30 surface-planarized to a predetermined degree after being separated from the ingot 2. In this example, optical measurement positions are set at a constant measurement pitch in each of the X-axis direction and the Y-axis direction. The measurement pitch is, for example, 1 mm, approximately. The X-axis direction is parallel to the scanning direction Ds illustrated in Fig. 8 or the like. Moreover, the Y-axis direction is parallel to the line feed direction Df illustrated in Fig. 8 or the like.

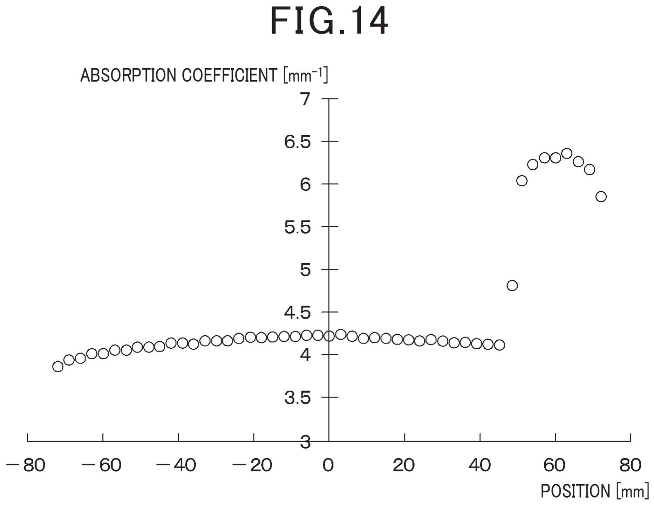

Here, Fig. 14 illustrates the manner of a change in the absorption coefficient of the laser beam B with a change in measurement position in a case where the optical measurement is performed at a plurality of measurement positions on a measurement line Lx as illustrated in Fig. 13. The measurement line Lx is an imaginary straight line passing through a center in the in-plane direction of the generated body 100 and parallel to the X-axis. In Fig. 14, the horizontal axis indicates, in millimeters (mm), measurement positions with the assumption that the center in the in-plane direction of the generated body 100 is the origin point, that is, "zero." As illustrated in Fig. 14, the absorption coefficient is not constant in the in-plane direction but changes with a change in measurement position. It should be noted that the absorption coefficient is obtained, that is, calculated, by Expression (1) below. In Expression (1) below, $\alpha$

denotes the absorption coefficient, D denotes a workpiece thickness, that is, a thickness of the generated body 100, and T denotes the transmittance.

[Math. 1]

$$\alpha = -\frac{1}{D}\ln(T) \qquad (1)$$

The present embodiment is effective especially in a case where the wafer 1 and the ingot 2 have a facet region RF as illustrate in Fig. 12 and Fig. 13. The facet region RF may also be referred to as "facet portion". A region other than the facet region RF is referred to as non-facet region RN hereinbelow. The non-facet region RN may also be referred to as "non-facet portion". It has been known that an intensity of the laser beam B that reaches the focal point BP is higher in the non-facet region RN than in the facet region RF. Specifically, a region with a high absorption coefficient on the right end side in Fig. 14 is equivalent of the facet region RF. Moreover, even the non-facet region RN having a lower absorption coefficient than the facet region RF may have a distribution in the in-plane direction, that is, a radial direction, as illustrated in Fig. 14. The "radial direction" is a direction radially extending from a center in an in-plane direction of the generated body 100 along the in-plane direction.

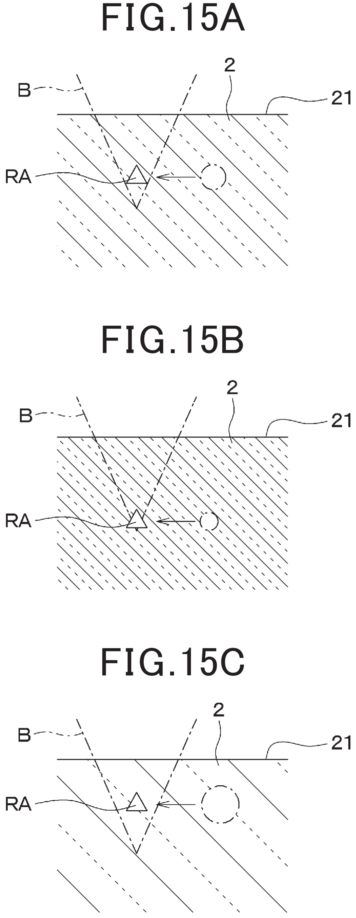

Fig. 15A to Fig. 15C illustrate the manner of a change in a generation position of the modified layer RA with a change in transmittance, that is, absorption coefficient. The density of hatching applied to the ingot 2 in the figure corresponds to transmittance or absorption coefficient. That is to say, a denser hatching is deemed to indicate a lower transmittance and, consequently, a higher absorption coefficient. The generation position of the modified layer RA, which is a position where the laser beam B is focused, may be indicated by a dimension in a depth direction of the ingot 2 from the ingot C-plane 21, which is the laser irradiation surface. Here, the depth direction of the ingot 2 is a direction parallel to the height direction of the ingot 2, in more detail, a direction from the ingot C-plane 21 toward the ingot Si-plane 22. In the figure, a circle drawn by a dash-dotted line beside the modified layer RA represents a focused state, that is, a beam diameter, of the laser beam B at the generation position of the modified layer RA.

First, referred to Fig. 15A, the laser beam B is focused while attenuating in accordance with the absorption coefficient as traveling inside the ingot 2 in the depth direction thereof. Then, when an energy density increases to a predetermined level due to focusing, a machining threshold is reached to form the modified layer RA. Here, in a case where the transmittance is low, that is, in a case where the absorption coefficient is high, the amount of attenuation is large, so that the energy density equivalent of the machining threshold is reached to generate the modified layer RA at a deep position where a focal cross-sectional area is smaller as illustrated in Fig.

15B. In contrast, in a case where the transmittance is high, the amount of attenuation is small, so that the energy density equivalent of the machining threshold is reached to generate the modified layer RA even at a shallow position where a focal cross-sectional area is larger as illustrated in Fig. 15C. As seen from the above, as the generation position of the modified layer RA varies depending on a difference in transmittance, that is, absorption coefficient, the surface of the separated generated body 100 becomes rough, resulting in an increase in machining allowance for grinding or polishing, that is, material loss.

Accordingly, in the present embodiment, the transmittance is measured at a plurality of positions in the in-plane direction and the irradiation conditions of the laser beam B at each of the plurality of positions in the in-plane direction are controlled based on the measurement result. Specifically, in the present embodiment, the absorption coefficient is obtained, that is, calculated, based on the transmittance measured in the generated body 100 generated in the past including the previous time. Then, in the present embodiment, a trend of change of the absorption coefficient in the height direction, that is, the depth direction, of the ingot 2 at each of the different positions in plane is obtained and the irradiation energy of the laser beam B is determined based on the trend of change. That is to say, for example, the irradiation energy is increased with a decrease in transmittance.

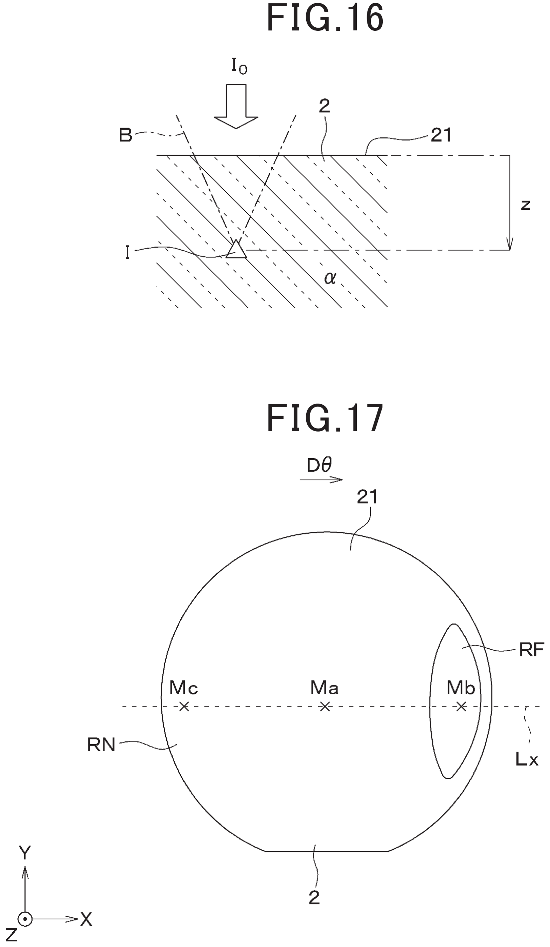

Description will be given below on a specific example where the irradiation conditions of the next laser beam B are controlled based on the optical measurement result of the previously obtained generated body 100. First, the transmittance of the previously obtained generated body 100, or the like is measured using a transmittance meter. At this time, a workpiece thickness, which is a thickness of the generated body 100, is also measured together. The absorption coefficient is calculated based on the measured transmittance and workpiece thickness and Expression (1) above. Then, an input energy, which is the irradiation energy of the laser beam B, is derived using Expression (2) below. In Expression (2) below and Fig. 16, $I_0$ denotes the input energy, I denotes the above-described machining threshold, which is a lowest applied energy necessary for property modification, and z denotes depth. k denotes the amount of change in the absorption coefficient in the depth direction, that is, the trend of change of the absorption coefficient in the depth direction of the ingot 2.

[Math. 2]

$$I_0 = k \cdot I \cdot e^{\alpha z} \qquad (2)$$

Description will be given below of a method of driving the amount of change in the absorption coefficient. As illustrated in Fig. 17, a center position in the in-plane direction of the ingot 2 is defined as an in-plane center position Ma. Moreover, a peripheral position of the ingot 2 located inside the facet region RF, which is a position on the measurement line Lx passing through the in-plane center position Ma and parallel to the X-axis, is defined as a first peripheral position Mb. Moreover, the opposite position to the first peripheral position Mb, which is a position on the measurement line Lx, is defined as a second peripheral position Mc. The second peripheral position Mc is a position almost symmetrical to the first peripheral position Mb with respect to the in-plane center position Ma.

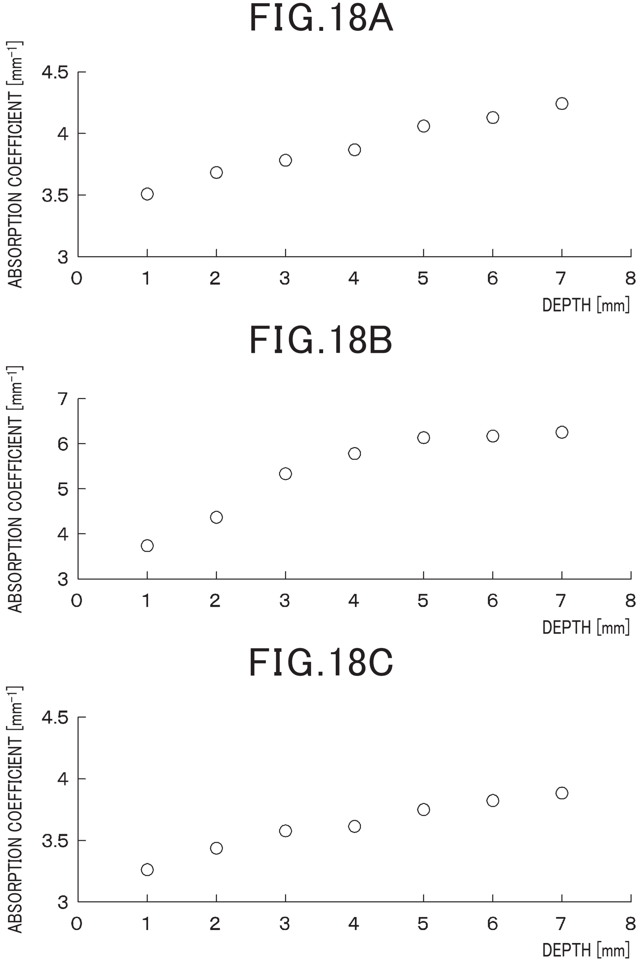

Fig. 18A illustrates the manner of a change in the absorption coefficient in the depth direction of the ingot 2 at the in-plane center position Ma. Fig. 18B illustrates the manner of a change in the absorption coefficient in the depth direction of the ingot 2 at the first peripheral position Mb. Fig. 18C illustrates the manner of a change in the absorption coefficient in the depth direction of the ingot 2 at the second peripheral position Mc. As illustrated in Fig. 18A to Fig. 18C, the change in the absorption coefficient in the depth direction of the ingot 2 has specific trend and differs depending on each of the in-plane positions. The amount of change in the absorption coefficient is derived based on the trend of change of the absorption coefficient in the depth direction depending on each of the in-plane positions and a value given by adding/multiplying the amount of change to/by the previously obtained absorption coefficient may be used to determine the input energy for the next machining.

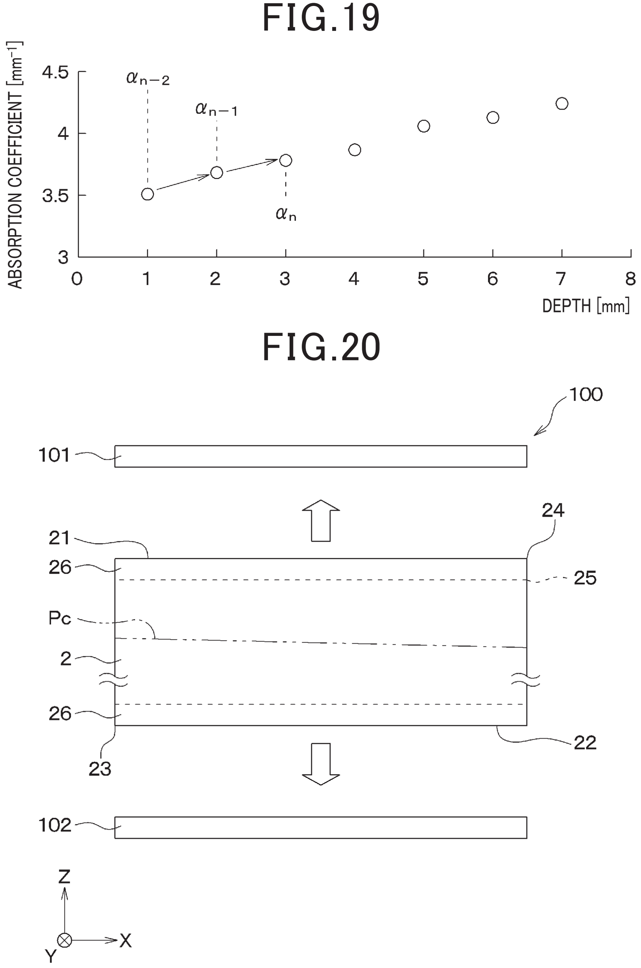

For example, it is possible to obtain, that is, calculate, an absorption coefficient estimated value $\alpha_n$ used for the current machining based on the amount of change between a previously obtained absorption coefficient $\alpha_{n-1}$ and an absorption coefficient $\alpha_{n-2}$ obtained before the previous one as illustrated in Fig. 19. Specifically, for example, a difference between the amount of change in the previously obtained absorption coefficient $\alpha_{n-1}$ and the absorption coefficient $\alpha_{n-2}$ obtained before the previous one is defined as the amount of change in the absorption coefficient, and the absorption coefficient estimated value $\alpha_n$ may be calculated by adding the amount of change in the absorption coefficient to the previously obtained absorption coefficient $\alpha_{n-1}$. Then, it is possible to determine the irradiation energy of the laser beam B based on the absorption coefficient estimated value $\alpha_n$. It should be noted that in calculating the amount of change in the absorption coefficient, statistical processing using a so-called "smoothing filter" or the like may be performed.

Moreover, a first generated body 101 and a second generated body 102 are generated as illustrated in Fig. 20. The first generated body 101 is a generated body 100 obtained from the one end side in the height direction of the ingot 2, that is, the ingot C-plane 21 side. The second generated body 102 is a generated body 100 obtained from the opposite end side in the height direction of the ingot 2, that is, the ingot Si-plane 22 side. Next, a first absorption coefficient, which is an absorption coefficient of the first generated body 101, and a second absorption coefficient, which is an absorption coefficient of the second generated body 102, are obtained. Then, using the higher one of the first absorption coefficient and the second absorption coefficient as an upper limit of the absorption coefficient, it is possible to determine the irradiation conditions, that is, the irradiation energy, of the laser beam B. In other words, using, as the upper limit, the absorption coefficient obtained from the generated body 100, that is, the wafer 1, with the higher absorption coefficient, a coefficient setting that prevents the absorption coefficient from exceeding this upper limit may be used.

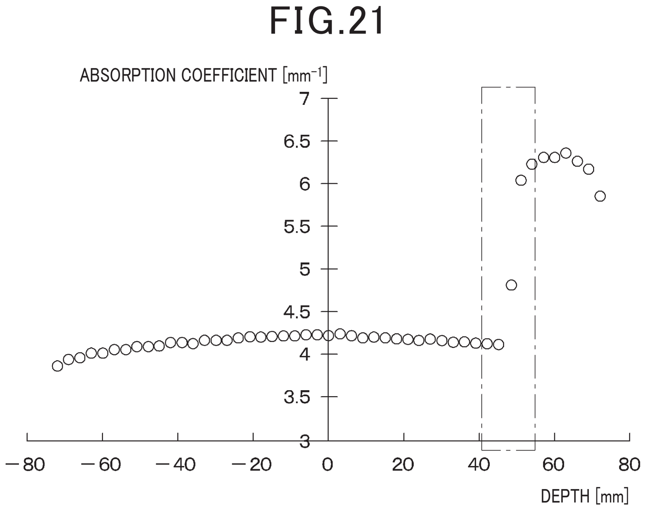

As for the measurement pitch for the optical measurement, the measurement may be performed at a regular pitch as illustrated in Fig. 12 but the measurement pitch is changeable, if necessary. That is to say, for example, pitches in the X-axis direction and in Y-axis direction may be different. Alternatively, for example, a finer measurement pitch may be used for a region where a change in the absorption coefficient is larger than in any other region, such as a region surrounded by a rectangle drawn by dash-dotted lines in Fig. 21. Specifically, such a region is, for example, a boundary portion between the non-facet region RN and the facet region RF. That is to say, the measurement pitch for such a boundary portion may be finer than that for any other region. It should be noted that the region where the measurement pitch is finer may include the whole of the facet region RF. In more detail, for example, referring to Fig. 21, the measurement pitch for a region on the right side relative to a measurement position of 40 mm may be finer than that for a region on the left side relative to the measurement position of 40 mm. In other words, a measurement pitch for a predetermined region including the non-facet region RN and the boundary portion between the non-facet region RN and the facet region RF may be finer than a measurement pitch for a region outside the predetermined region.

(Third Embodiment)

In the present embodiment, the pattern of irradiation and scanning of the laser beam B of the above-described first embodiment is partially transformed. That is to say, in the above-described first embodiment, the spacing in scanning direction Ds between the preceding beam B1 and the following beam B2 is N times, that is, an integer multiple of, the irradiation pitch for the preceding beam B1. Incidentally, during actual machining, the preceding irradiation position PR1, which is a position of irradiation with the preceding beam B1, and the following irradiation position PR2, which is a position of irradiation with the following beam B2, are not always exactly the same and an error in the in-plane direction may occur. Moreover, the disclosure corresponding to the above-described first embodiment is that the irradiation mark RM formed by irradiation with the preceding beam B1 is irradiated with the following beam B2 and does not require, as an essential requirement, that the irradiation position PR1 and the following irradiation position PR2 be exactly the same in the in-plane direction. Accordingly, the spacing between the preceding beam B1 and the following beam B2 may not be an integer multiple of the irradiation pitch for the preceding beam B1 (for example, (N + 0.1) times, or the like). It should be noted that these matters are, of course, obvious to those skilled in the art but are mentioned for the sake of completeness. That is to say, these matters are within a scope disclosed in Japanese Patent Application No. 2023-87816 filed on May 29, 2023.

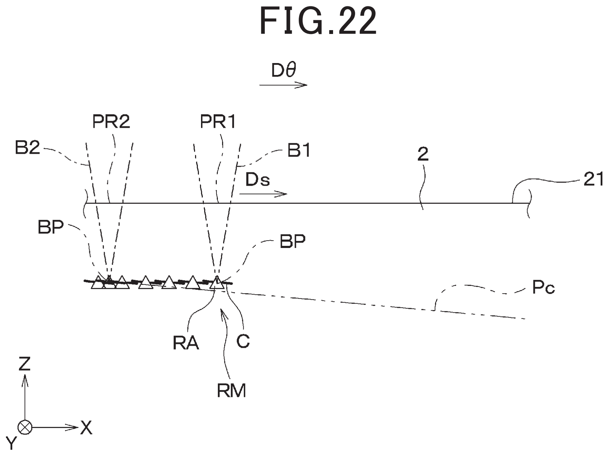

In this regard, in the present embodiment, a portion between a pair of irradiation marks RM, which are formed by irradiation with the preceding beam B1 and arrayed along the scanning direction Ds, is irradiated with the following beam B2 as illustrated in Fig. 22. That is to say, the spacing between the preceding beam B1 and the following beam B2 is a non-integer multiple of the irradiation pitch for the preceding beam B1, specifically, $N + \delta$. $\delta$ is typically, for example, 0.5 or a value close to it (that is, 0.4 to 0.6, approximately). Then, in the present embodiment, irradiation with the preceding beam B1 and irradiation with the following beam B2 are performed such that the irradiation mark RM formed by the irradiation with the preceding beam B1 and the irradiation mark RM to be formed by the irradiation with the following beam B2 are joined. Herein, it does not matter whether the irradiation mark RM generated by the preceding beam B1 is irradiated with the following beam B2. Moreover, the application energies of the preceding beam B1 and the following beam B2 may be set to values larger than that of the above-described first embodiment in accordance with a size of the irradiation pitch or may be almost the same. According to the present embodiment, a portion between a plurality of irradiation marks RM formed in array at substantially the same depth using the preceding beam B1 is irradiated with the following beam B2, thereby joining the irradiation mark RM formed by irradiation with the preceding beam B1 and the irradiation mark RM to be formed by irradiation with the following beam B2. This may produce an effect similar to that of the above-described first embodiment. It should be noted that in a case where the following beam B2 is not irradiated on the modified layer RA formed using the preceding beam B1, there may be a concern about an influence of reflection by the crack C as described above. Accordingly, in this case, an irradiation spacing in the scanning direction Ds of the preceding beam B1 may be set such that a gap between adjacent ones of the cracks C made by the preceding beam B1 along the scanning direction Ds is irradiated with the following beam B2.

(Modification Example)

The present disclosure is not limited to the above-described embodiments. It is thus possible to modify the above-described embodiments, if necessary. Description will be made below on representative modification examples. In the following description on the modification examples, a difference from the above-described embodiments will be mainly described. Moreover, parts that are the same as or equivalent of each other in the above-described embodiments and the modification examples are designated by the same reference numeral. Accordingly, for a component designated by the same reference numeral as in the above-described embodiments in the following description on the modification examples, the description in the above-described embodiments may be incorporated by reference, if necessary, unless there is a technical inconsistency or a particular additional description.

The present disclosure is not limited to a specific configuration described in the above-described embodiments. That is to say, for example, there is no particular limitation on the outer diameter and the planar shape (for example, the presence/absence of a so-called orientation flat) of the wafer 1, that is, the ingot 2. There is also no particular limitation on the magnitude of the off-angle θ. Moreover, in the above-described embodiments, the wafer C-plane 11 or the ingot C-plane 21 is not identical to the exact crystallographical C-plane, that is, the (0001) plane Pc. However, even in such a case, that plane is permitted to be referred as "C-plane" under normal conventions, so that the term "C-plane" is used. Incidentally, the present disclosure is not limited to such a mode. That is to say, the wafer C-plane 11 or the ingot C-plane 21 may be identical to the exact crystallographical C-plane, that is, the (0001) plane Pc. In other words, the off-angle θ may be zero degrees.

In the above-described embodiments, the separation layer 23 is formed on the ingot C-plane 21 side by "C-plane-side irradiation", which is an irradiation of the ingot C-plane 21 with the laser beam B. However, the present disclosure is not limited to such a mode. That is to say, the present disclosure is also applicable to "Si-plane-side irradiation", which refers to forming the separation layer 23 on the ingot Si-plane 22 side by irradiation of the ingot Si-plane 22 with the laser beam B.

Depending on the irradiation conditions or scanning conditions of the laser beam B, the separation surface 32 may have a surface condition that allows the separation surface 32 to be favorably ground or polished even though being provided directly to the ECMG or ECMP step. Accordingly, the rough grinding step for the separation surface 32 illustrated in Fig. 2 may be omitted. The same applies to rough grinding of the upper surface of the ingot 2 after the wafer separation step. The same applies to the rough grinding step illustrated in Fig. 11.

There is also no particular limitation on the number of arrays in the scanning direction Ds, that is, the off-angle direction Dθ, of the laser beam B scanned during a single laser scan. That is to say, although the two laser beams B, the preceding beam B1 and the following beam B2, are arrayed in the scanning direction Ds in the above-described embodiments, the number thereof may be three or more. In other words, in the above-described first embodiment, the irradiation mark RM, that is, the modified layer RA, may be gradually enlarged by dividing irradiation of a single irradiation position PR with the laser beam B into three or more irradiations and performing them. As for the laser beam B scanned during a single laser scan, the number of arrays in the line feed direction Df and the array pattern in the scanning direction Ds may be changed from the specific examples described in the above-described embodiments, if necessary.

Specifically, for example, the scanning example illustrated in Fig. Fig. 10 is an example where the six laser beams B in total, two in the scanning direction Ds and three in the line feed direction Df, are scanned in the scanning direction Ds. Moreover, the positions in the scanning direction Ds of the three laser beams B or irradiation positions PR arrayed in the line feed direction Df are set such that they are offset by increments of the predetermined amount toward the line feed direction Df. However, as described above, the present disclosure is not limited to such an array pattern.

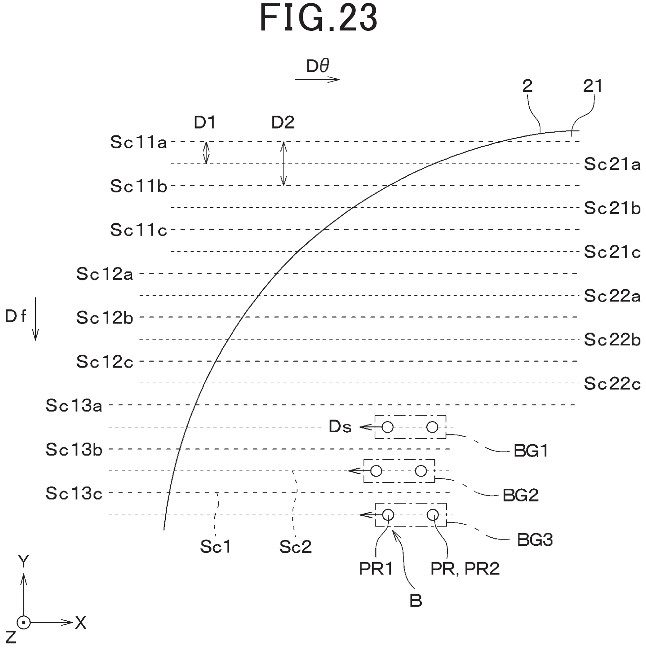

That is to say, for example, a scanning example as illustrated in Fig. 23 is also possible. In this scanning example, three groups of the laser beams B, first beam group BG1, a second beam group BG2, and a third beam group BG3, are arrayed in this order in the line feed direction Df. Then, the second beam group BG2 is disposed at a position projecting in the scanning direction Ds with respect to the first beam group BG1 and the third beam group BG3. That is to say, the first beam group BG1, the second beam group BG2, and the third beam group BG3 are disposed substantially in a V-shape. This may favorably reduce enlargeing of a machining device configuration with an increase in an irradiation region of a plurality of simultaneously scanned laser beams B. It should be noted that although the first beam group BG1 to the third beam group BG3 are each a group of a plurality of laser beams B arranged side by side along the scanning direction Ds, the number of the laser beams B contained in it is not limited to two as illustrated in Fig. 23 and may be three or more. Moreover, the number of the beam groups such as the first beam group BG1 is not limited to three as illustrated in Fig. 23 and may be two or may be four or more.

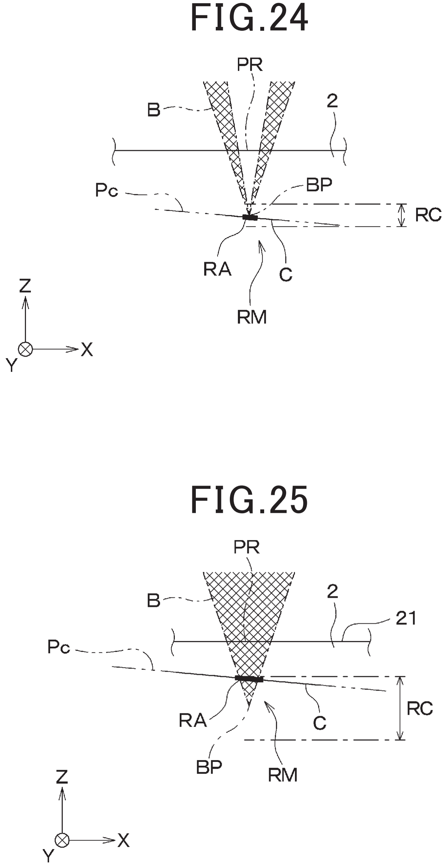

Adjusting the beam properties of the laser beam B, such as a beam shape, makes it possible to further improve machining properties. Specifically, for example, the laser beam B may have a beam shape in which the laser beam B focuses into a point at the focal point BP while becoming annular, that is, hollow before the focal point BP as illustrated in Fig. 24. Such an annular laser beam B and a device that generates the laser beam B and irradiates an object to be machined with the laser beam B are already publicly known or well-known at the time of filing of the present application (for example, see JP 2006-130691 A, JP 2014-147946 A, or the like). Accordingly, a detailed description on a generation device and a generation method of the laser beam B is omitted herein.

Fig. 24 illustrates the manner of formation of the irradiation mark RM using the annular laser beam B. In contrast, Fig. 25 illustrates the manner of formation of the irradiation mark RM using a non-annular, that is, solid, laser beam B.

As illustrated in Fig. 25, in a case where the solid laser beam B is used, the modified layer RA, which is formed by decomposing SiC into Si and C through irradiation with the laser beam B, may be generated at a depth different from that of the focal point BP. Thus, a depth of the irradiation mark RM, which includes the modified layer RA and the crack C developing from the modified layer RA, may also be different from that of the focal point BP. Specifically, for example, at a position shallower than the focal point BP, the application density of the energy resulting from irradiation with the laser beam B may increase to the level allowing for the generation of the modified layer RA. Then, the modified layer RA may be generated at a shallower position than that of the focal point BP. The generation depth of the modified layer RA may vary depending on a variation in the irradiation energy of the laser beam B, a variation in the refractive index of the ingot 2, a variation in an optical system of a focusing device for the laser beam B, or the like. A region where the modified layer RA may be generated is represented as a modifiable range RC in the figure.

In contrast, in a case where the annular laser beam B is used, the laser beam B travels with a relatively low energy density until reaching a depth close to the focal point BP and the energy density rapidly rises at a joint portion generated at the depth close to the focal point BP as illustrated in Fig. 24. Thus, a depth where the application density of the energy resulting from irradiation with the laser beam B increases to the level allowing for the generation of the modified layer RA is limited to the depth close to the focal point BP. That is to say, it is difficult to increase the application density of the energy resulting from irradiation with the laser beam B to the level allowing for the generation of the modified layer RA at a position shallower than that of the focal point BP as, for example, in a case where the solid laser beam B is used. Consequently, unlike the case where the solid laser beam B is used, the modifiable range RC is limited to a narrow depth range centered about the depth of the focal point BP. Thus, the modified layer RA is stably generated at the depth close to the focal point BP. This may favorably reduce a variation in the generation depth of the modified layer RA. In other words, the separation layer 23 can be formed as thin as possible and the machining allowance for grinding or polishing after separation may be favorably reduced. Therefore, according to the present embodiment, it is possible to enhance manufacturing efficiency more than ever before.

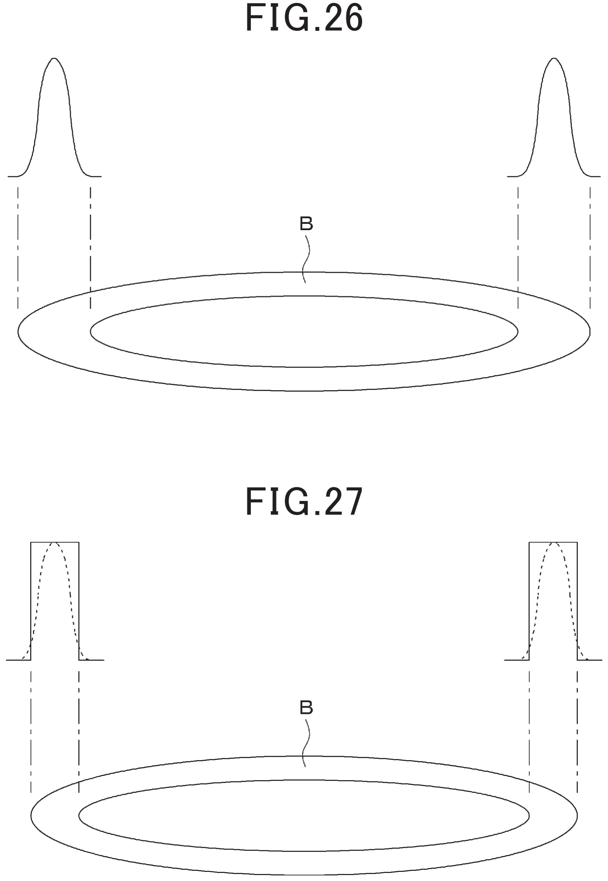

Here, the energy distribution in a beam radial direction of the annular laser beam B illustrated in Fig. 24 may be a usual Gaussian distribution illustrated in Fig. 26 but is suitably in a top-hat shape shown by solid lines in Fig. 27. Such a top-hat energy distribution may be achieved by removing a tail portion of a Gaussian distribution shown by broken lines in the figure using an optical system or the like. Such a top-hat energy distribution makes it possible to further narrow the modifiable range RC illustrated in Fig. 24.

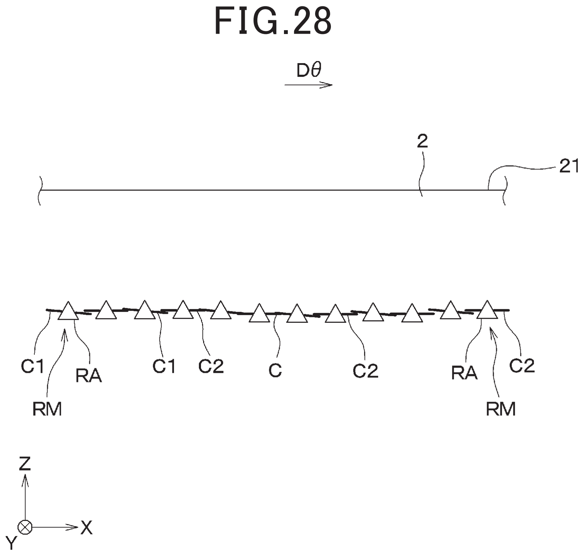

In the above-described embodiments and specific examples, the development direction of the crack C is inclined by the off-angle θ with respect to the in-plane direction parallel to the ingot C-plane 21. However, the crack C having an inclination pattern different from such an inclination pattern may also actually be generated by irradiation with the laser beam B. Specifically, in addition to a first-type crack C1 inclined with respect to the in-plane direction by the off-angle θ, a second-type crack C2 with an inclination different therefrom may be generated as illustrated in Fig. 28. The second-type crack C2 is the nearly horizontal crack C along the in-plane direction. In other words, the second-type crack C2 has an inclination that is nearly horizontal as compared with the first-type crack C1. It should be noted that the "horizontal" is deemed to mean being parallel to the ingot C-plane 21 herein. The generation pattern of the crack C as illustrated in Fig. 28 may be favorably achieved by irradiation with the laser beam B as described in the above-described embodiments.

Needless to say, unless explicitly stated as being particularly essential, clearly considered essential in principle, or the like, the elements constituting the above-described embodiments are not necessarily essential. In addition, in a case where numerical values, such as the number, amount, range, etc., of a component are mentioned, unless explicitly stated as being particularly essential, clearly considered as being limited to specific numerical values in principle, or the like, the present disclosure is by no means limited to the specific numerical values. Likewise, in a case where the shape, direction, positional relationship, etc. of a component or the like are mentioned, unless explicitly stated as being particularly essential, considered as being limited to a specific shape, direction, positional relationship, etc. in principle, or the like, the present disclosure is by no means limited to the shape, direction, positional relationship, etc.

Modification examples are also not limited to the above examples. That is to say, for example, in addition to the combinations exemplified above, a plurality of embodiments may be combined with each other unless a technical inconsistency arises. Likewise, a plurality of modification examples may be combined with each other unless a technical inconsistency arises.

(Points of the Present Disclosure)

As is apparent from the descriptions on the embodiments and the modification examples as described above, the above-described present disclosure is understandable as, for example, points recited below.

[Point 1-1]

A laser machining method of irradiating a machining target (2) made of a semiconductor material with a laser beam (B), the method including

a modified layer formation in which a modified layer (RA) is formed at a predetermined depth from a surface (21) of the machining target by irradiating the surface with the laser beam which is transmissive to the surface, in which
in the modified layer formation,
by performing a laser scan for a plurality of times with a change in position within the surface in a second direction (Df), a plurality of irradiation trajectory lines (Ls) are formed along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks of the laser beam and linear along the first direction, and
in a single laser scan, the irradiation marks are formed at a plurality of the respective irradiation positions by intermittently irradiating with the laser beam with a relative movement of the laser beam relative to the machining target along the first direction, and the irradiation marks formed by the irradiation with the laser beam that precedes are irradiated with the laser beam that follows.

[Point 1-2]

The laser machining method according to Point 1-1, in which
the laser scan is performed between adjacent ones of the irradiation trajectory lines in the second direction.

[Point 1-3]

The laser machining method according to Point 1-1 or 1-2, in which

the machining target is a single crystal SiC having a c-axis (Lc) and a C-plane (Pc) that are orthogonal to each other,
the c-axis is defined in a state where a center axis (L) orthogonal to the surface is inclined in an off-angle direction (Dθ) by an off-angle (θ) exceeding zero degrees, and
the first direction is parallel to the off-angle direction.

[Point 1-4]

The laser machining method according any one of Points 1-1 to 1-3, in which

a direction of the relative movement is reversed between the single laser scan and the next single laser scan.

[Point 1-5]

The laser machining method according any one of Points 1-1 to 1-4, in which
in the single laser scan, the plurality of irradiation trajectory lines are formed by irradiating the surface with a plurality of the laser beams different at least in the irradiation position in the second direction.

[Point 1-6]

The laser machining method according any one of Points 1-1 to 1-5, including
controlling an irradiation condition of the laser beam based on a measurement result of a transmittance of the laser beam through the semiconductor material.

[Point 1-7]

The laser machining method according to Point 1-6, including:

obtaining a trend of change in a depth direction of an absorption coefficient of the laser beam in the semiconductor material based on the measurement result; and
determining the irradiation condition based on the obtained trend of change.

[Point 1-8]

The laser machining method according to Point 1-6 or 1-7, in which
a measurement pitch for the transmittance is narrower at a boundary portion between a facet region (RF) and a non-facet region (RN) than at any other portion.

[Point 1-9]

The laser machining method according any one of Points 1-1 to 1-8, in which
the machining target is a single crystal SiC ingot.

[Point 1-10]

The laser machining method according any one of Points 1-1 to 1-9, in which

the laser scan is performed such that DYave / DPave $\leq 5$ is satisfied,
where:

DY denotes a local maximum width in the second direction of the modified layer;
DP denotes a local maximum spacing in the first direction, the local maximum spacing being a spacing between the modified layer and adjacent another modified layer at a position corresponding to the local maximum width of the modified layer;
DYave denotes an average value of the local maximum width; and DPave denotes an average value of the local maximum spacing.

[Point 1-11]

The laser machining method according to Point 1-10, in which
the laser scan is performed such that DYave/DPave $\leq 2$ is satisfied.

[Point 1-12]

The laser machining method according to Point 1-11, in which
the laser scan is performed such that DYave/DPave $= 0.7$ to 1.3 is satisfied.

[Point 1-13]

The laser machining method according any one of Points 1-1 to 1-12, in which
the single laser scan includes relatively moving two of the laser beams different in position in the first direction with respect to the machining target, the two laser beams being a preceding beam (B1) and a following beam (B2).

[Point 1-14]

The laser machining method according to Point 1-13, in which
the irradiation with the preceding beam and the irradiation with the following beam are simultaneously performed.

[Point 1-15]

The laser machining method according any one of Points 1-1 to 1-14, in which
the irradiation marks are each formed by a modified region (RA) and a crack (C), the modified region being generated by a modification of the semiconductor material through an irradiation with the laser beam, the crack originating at the modified region, and
the crack includes a first-type crack developing in a direction inclined with respect to the surface by an off-angle ($\theta$) and a second-type crack having an inclination closer to the surface than the first-type crack.

[Point 2-1]

A wafer manufacturing method of obtaining a wafer (1) from an ingot (2), the method including

a separation layer formation in which a separation layer (23) is formed at a depth corresponding to a thickness of the wafer from a surface (21) of the ingot on one end side in a height direction by irradiating the surface with a laser beam which is transmissive to the surface, in which
in the separation layer formation,
the separation layer is formed by performing a laser scan for a plurality of times with a change in position within the surface in a second direction (Df) to form a plurality of irradiation trajectory lines (Ls) along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks (RM) of the laser beam and linear along the first direction, and
in a single laser scan, the irradiation marks are formed at a plurality of the respective irradiation positions by intermittently irradiating with the laser beam with a relative movement of the laser beam relative to the ingot along the first direction, and the irradiation marks formed by the irradiation with the laser beam that precedes are irradiated with the laser beam that follows.

[Point 2-2]

The wafer manufacturing method according to Point 2-1, in which
the laser scan is performed between adjacent ones of the irradiation trajectory lines in the second direction.

[Point 2-3]

The wafer manufacturing method according to Point 2-1 or 2-2, in which

the ingot is a single crystal SiC ingot having a c-axis (Lc) and a C-plane (Pc) that are orthogonal to each other,
the c-axis is defined in a state where a center axis (L) orthogonal to the surface is inclined in an off-angle direction (Dθ) by an off-angle (θ) exceeding zero degrees, and
the first direction is parallel to the off-angle direction.

[Point 2-4]

The wafer manufacturing method according to any one of Points 2-1 or 2-3, in which
a direction of the relative movement is reversed between the single laser scan and the next single laser scan.

[Point 2-5]

The wafer manufacturing method according to any one of Points 2-1 or 2-4, in which
in the single laser scan, the plurality of irradiation trajectory lines are formed by irradiating the surface with a plurality of the laser beams different at least in the irradiation position in the second direction.

[Point 2-6]

The wafer manufacturing method according to any one of Points 2-1 or 2-5, including
controlling an irradiation condition of the laser beam based on a measurement result of a transmittance of the laser beam through a material forming the ingot.

[Point 2-7]

The wafer manufacturing method according to Point 2-6, including:

obtaining a trend of change in the height direction of an absorption coefficient of the laser beam in the material based on the measurement result; and
determining the irradiation condition based on the obtained trend of change.

[Point 2-8]

The wafer manufacturing method according to Point 2-6 or 2-7, in which
a measurement pitch for the transmittance is narrower at a boundary portion between a facet region (RF) and a non-facet region (RN) than at any other portion.

[Point 2-9]

The wafer manufacturing method according to any one of Points 2-1 to 2-8, in which

the laser scan is performed such that DYave / DPave ≤ 5 is satisfied,
where:

DY denotes a local maximum width in the second direction of the modified layer;
DP denotes a local maximum spacing in the first direction, the local maximum spacing being a spacing between the modified layer and adjacent another modified layer at a position corresponding to the local maximum width of the modified layer;
DYave denotes an average value of the local maximum width; and
DPave denotes an average value of the local maximum spacing.

[Point 2-10]

The wafer manufacturing method according to Point 2-9, in which the laser scan is performed such that DYave/DPave ≤ 2 is satisfied.

[Point 2-11]

The wafer manufacturing method according to Point 2-10, in which the laser scan is performed such that DYave/DPave = 0.7 to 1.3 is satisfied.

[Point 2-12]

The wafer manufacturing method according to any one of Points 2-1 to 2-11, in which the single laser scan includes relatively moving two of the laser beams different in position in the first direction with respect to the machining target, the two laser beams being a preceding beam (B1) and a following beam (B2).

[Point 2-13]

The wafer manufacturing method according to Point 2-12, in which the irradiation with the preceding beam and the irradiation with the following beam are simultaneously performed.

[Point 2-14]

The wafer manufacturing method according to any one of Points 2-1 to 2-13, in which

the irradiation marks are each formed by a modified region (RA) and a crack (C), the modified region being generated by a modification of the semiconductor material through an irradiation with the laser beam, the crack originating at the modified region, and
the crack includes a first-type crack developing in a direction inclined with respect to the surface by an off-angle (θ) and a second-type crack having an inclination closer to the surface than the first-type crack.

[Point 3-1]

A laser machining method of irradiating a machining target (2) made of a semiconductor material with a laser beam (B), the method including

a modified layer formation in which a modified layer (RA) is formed at a predetermined depth from a surface (21) of the machining target by irradiating the surface with the laser beam which is transmissive to the surface, in which
in the modified layer formation,
by performing a laser scan for a plurality of times with a change in position within the surface in a second direction (Df), a plurality of irradiation trajectory lines (Ls) are formed along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks of the laser beam and linear along the first direction, and
in a single laser scan, the irradiation marks are formed at a plurality of the respective irradiation positions by intermittently irradiating with the laser beam with a relative movement of the laser beam relative to the machining target along the first direction, and a portion between a pair of the irradiation marks formed by an irradiation with a preceding beam (B1) and arrayed along the first direction is subjected to an irradiation with a following beam (B2), the preceding beam being the laser beam that precedes, the following beam being the laser beam that follows.

[Point 3-2]

The laser machining method according to Point 3-1, in which in the single laser scan, the irradiation with the preceding beam and the irradiation with the following beam are performed such that the irradiation marks formed by the irradiation with the preceding beam and the irradiation marks to be formed by the irradiation with the following beam are joined.

[Point 3-3]

The laser machining method according to Point 3-1 or 3-2, in which the laser scan is performed between adjacent ones of the irradiation trajectory lines in the second direction.

[Point 3-4]

The laser machining method according to any one of Points 3-1 to 3-3, in which

the machining target is a single crystal SiC having a c-axis (Lc) and a C-plane (Pc) that are orthogonal to each other,
the c-axis is defined in a state where a center axis (L) orthogonal to the surface is inclined in an off-angle direction (Dθ) by an off-angle (θ) exceeding zero degrees, and
the first direction is parallel to the off-angle direction.

[Point 3-5]

The laser machining method according to any one of Points 3-1 to 3-4, in which
a direction of the relative movement is reversed between the single laser scan and the next single laser scan.

[Point 3-6]

The laser machining method according to any one of Points 3-1 to 3-5, in which
in the single laser scan, the plurality of irradiation trajectory lines are formed by irradiating the surface with a plurality of the preceding beams and the following beams, the plurality of the preceding beams and the following beams being different in the irradiation position in the second direction.

[Point 3-7]

The laser machining method according to any one of Points 3-1 to 3-6, including
Controlling an irradiation condition of the laser beam based on a measurement result of a transmittance of the laser beam through the semiconductor material.

[Point 3-8]

The laser machining method according to Point 3-7, including:

obtaining a trend of change in a depth direction of an absorption coefficient of the laser beam in the semiconductor material based on the measurement result; and
determining the irradiation condition based on the obtained trend of change.

[Point 3-9]

The laser machining method according to Point 3-7 or 3-8, in which
a measurement pitch for the transmittance is narrower at a boundary portion between a facet region (RF) and a non-facet region (RN) than at any other portion.

[Point 3-10]

The laser machining method according to any one of Points 3-1 to 3-9, in which
the machining target is a single crystal SiC ingot.

[Point 3-11]

The laser machining method according to any one of Points 3-1 to 3-10, in which

the laser scan is performed such that DYave / DPave $\leq 5$ is satisfied,
where:

DY denotes a local maximum width in the second direction of the modified layer;
DP denotes a local maximum spacing in the first direction, the local maximum spacing being a spacing between the modified layer and adjacent another modified layer at a position corresponding to the local maximum width of the modified layer;
DYave denotes an average value of the local maximum width; and
DPave denotes an average value of the local maximum spacing.

[Point 3-12]

The laser machining method according to Point 3-11, in which
the laser scan is performed such that DYave/DPave $\leq 2$ is satisfied.

[Point 3-13]

The laser machining method according to Point 3-12, in which
the laser scan is performed such that DYave/DPave = 0.7 to 1.3 is satisfied.

[Point 3-14]

The laser machining method according to any one of Points 3-1 to 3-13, in which
the single laser scan includes relatively moving two of the laser beams different in position in the first direction with respect to the machining target, the two laser beams being the preceding beam and the following beam.

[Point 3-15]

The laser machining method according to Point 3-14, in which
the irradiation with the preceding beam and the irradiation with the following beam are simultaneously performed.

[Point 3-16]

The laser machining method according to any one of Points 3-1 to 3-15, in which

the irradiation marks are each formed of a modified region (RA) and a crack (C), the modified region being generated by a modification of the semiconductor material through the irradiation with the laser beam, the crack originating at the modified region, and

the crack includes a first-type crack developing in a direction inclined with respect to the surface by an off-angle ($\theta$) and a second-type crack having an inclination closer to the surface than the first-type crack.

[Point 4-1]

A wafer manufacturing method of obtaining a wafer (1) from an ingot (2), the method including

a separation layer formation in which a separation layer (23) is formed at a depth corresponding to a thickness of the wafer from a surface (21) of the ingot on one end side in a height direction by irradiating the surface with a laser beam which is transmissive to the surface, in which
in the separation layer formation,
the separation layer is formed by performing a laser scan for a plurality of times with a change in position within the surface in a second direction (Df) to form a plurality of irradiation trajectory lines (Ls) along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks (RM) of the laser beam and linear along the first direction, and
in a single laser scan, the irradiation marks are formed at a plurality of the respective irradiation positions by intermittently irradiating with the laser beam with a relative movement of the laser beam relative to the ingot along the first direction, and a portion between a pair of the irradiation marks formed by an irradiation with a preceding beam (B1) and arrayed along the first direction is subjected to an irradiation with a following beam (B2), the preceding beam being the laser beam that precedes, the following beam being the laser beam that follows.

[Point 4-2]

The wafer manufacturing method according to Point 4-1, in which
in the single laser scan, the irradiation with the preceding beam and the irradiation with the following beam are performed such that the irradiation marks formed by the irradiation with the preceding beam and the irradiation marks to be formed by the irradiation with the following beam are joined.

[Point 4-3]

The wafer manufacturing method according to Point 4-1 or 4-2, in which

the laser scan is performed between adjacent ones of the irradiation trajectory lines in the second direction.

[Point 4-4]

The wafer manufacturing method according to any one of Points 4-1 to 4-3, in which

the ingot is a single crystal SiC ingot having a c-axis (Lc) and a C-plane (Pc) that are orthogonal to each other,
the c-axis is defined in a state where a center axis (L) orthogonal to the surface is inclined in an off-angle direction (D$\theta$) by an off-angle ($\theta$) exceeding zero degrees, and
the first direction is parallel to the off-angle direction.

[Point 4-5]

The wafer manufacturing method according to any one of Points 4-1 to 4-4, in which
a direction of the relative movement is reversed between the single laser scan and the next single laser scan.

[Point 4-6]

The wafer manufacturing method according to any one of Points 4-1 to 4-5, in which
in the single laser scan, the plurality of irradiation trajectory lines are formed by irradiating the surface with a plurality of the preceding beams and the following beams, the plurality of the preceding beams and the following beams being different in the irradiation position in the second direction.

[Point 4-7]

The wafer manufacturing method according to any one of Points 4-1 to 4-6, including
Controlling an irradiation condition of the laser beam based on a measurement result of a transmittance of the laser beam through a material forming the ingot.

[Point 4-8]

The wafer manufacturing method according to Point 4-7, including:

obtaining a trend of change in the height direction of an absorption coefficient of the laser beam in the material based on the measurement result; and
determining the irradiation condition based on the obtained trend of change.

[Point 4-9]

The wafer manufacturing method according to Point 4-7 or 4-8 in which

a measurement pitch for the transmittance is narrower at a boundary portion between a facet region (RF) and a non-facet region (RN) than at any other portion.

[Point 4-10]

The wafer manufacturing method according to any one of Points 4-1 to 4-9, in which

the laser scan is performed such that DYave / DPave ≤ 5 is satisfied,
where:

DY denotes a local maximum width in the second direction of a modified layer (RA) formed inside the ingot by the irradiation with the laser beam;
DP denotes a local maximum spacing in the first direction, the local maximum spacing being a spacing between the modified layer and adjacent another modified layer at a position corresponding to the local maximum width of the modified layer;
DYave denotes an average value of the local maximum width; and
DPave denotes an average value of the local maximum spacing.

[Point 4-11]

The wafer manufacturing method according to Point 4-10, in which
the laser scan is performed such that DYave/DPave ≤ 2 is satisfied.

[Point 4-12]

The wafer manufacturing method according to Point 4-11, in which
the laser scan is performed such that DYave/DPave = 0.7 to 1.3 is satisfied.

[Point 4-13]

The wafer manufacturing method according to any one of Points 4-1 to 4-12, in which
the single laser scan includes relatively moving two of the laser beams different in position in the first direction with respect to the machining target, the two laser beams being the preceding beam and the following beam.

[Point 4-14]

The wafer manufacturing method according to Point 4-13, in which
the irradiation with the preceding beam and the irradiation with the following beam are simultaneously performed.

[Point 4-15]

The wafer manufacturing method according to any one of Points 4-1 to 4-14, in which

the irradiation marks are each formed of a modified region (RA) and a crack (C), the modified region being generated by a modification of the semiconductor material through the irradiation with the laser beam, the crack originating at the modified region, and
the crack includes a first-type crack developing in a direction inclined with respect to the surface by an off-angle (θ) and a second-type crack having an inclination closer to the surface than the first-type crack.

[Point 5-1]

A laser machining method of irradiating a machining target (2) made of a semiconductor material with a laser beam (B), the method including

a modified layer formation in which a modified layer (RA) is formed at a predetermined depth from a surface (21) of the machining target by irradiating the surface with the laser beam which is transmissive to the surface, in which
in the modified layer formation,
by performing a laser scan for a plurality of times with changes in position within the surface in a second direction (Df), a plurality of irradiation trajectory lines (Ls) are formed along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks of the laser beam and linear along the first direction, and
in a single laser scan, the irradiation marks are formed at a plurality of the respective irradiation positions by intermittently irradiating with the laser beam with a relative movement of the laser beam relative to the machining target along the first direction, and a portion between a pair of the irradiation marks formed by an irradiation with a preceding beam (B1) and arrayed along the first direction is subjected to an irradiation with a following beam (B2) to join the irradiation marks formed by the irradiation with the preceding beam and the irradiation marks to be formed by the irradiation with the following beam, the preceding beam being the laser beam that precedes, the following beam being the laser beam that follows.

[Point 5-2]

The laser machining method according to Point 5-1, in which
the laser scan is performed between adjacent ones of the irradiation trajectory lines in the second direction.

[Point 5-3]

The laser machining method according to Point 5-1 or 5-2, in which

> the machining target is a single crystal SiC having a c-axis (Lc) and a C-plane (Pc) that are orthogonal to each other,
> the c-axis is defined in a state where a center axis (L) orthogonal to the surface is inclined in an off-angle direction (Dθ) by an off-angle (θ) exceeding zero degrees, and
> the first direction is parallel to the off-angle direction.

[Point 5-4]

The laser machining method according to any one of Points 5-1 to 5-3, in which
a direction of the relative movement is reversed between the single laser scan and the next single laser scan.

[Point 5-5]

The laser machining method according to any one of Points 5-1 to 5-4, in which
in the single laser scan, the plurality of irradiation trajectory lines are formed by irradiating the surface with a plurality of the preceding beams and the following beams, the plurality of the preceding beams and the following beams being different in the irradiation position in the second direction.

[Point 5-6]

The laser machining method according to any one of Points 5-1 to 5-5, including
controlling an irradiation condition of the laser beam based on a measurement result of a transmittance of the laser beam through the semiconductor material.

[Point 5-7]

The laser machining method according to Point 5-6, including:

> obtaining a trend of change in a depth direction of an absorption coefficient of the laser beam in the semiconductor material based on the measurement result; and
> determining the irradiation conditions based on the obtained trend of change.

[Point 5-8]

The laser machining method according to Point 5-6 or 5-7, in which
a measurement pitch for the transmittance is narrower at a boundary portion between a facet region (RF) and a non-facet region (RN) than at any other portion.

[Point 5-9]

The laser machining method according to any one of Points 5-1 to 5-8, in which
the machining target is a single crystal SiC ingot.

[Point 5-10]

The laser machining method according to any one of Points 5-1 to 5-9, in which

> the laser scan is performed such that DYave / DPave $\leq$ 5 is satisfied,
> where:

> > DY denotes a local maximum width in the second direction of the modified layer;
> > DP denotes a local maximum spacing in the first direction, the local maximum spacing being a spacing between the modified layer and adjacent another modified layer at a position corresponding to the local maximum width of the modified layer;
> > DYave denotes an average value of the local maximum width; and
> > DPave denotes an average value of the local maximum spacing.

[Point 5-11]

The laser machining method according to Point 5-10, in which
the laser scan is performed such that DYave/DPave $\leq$ 2 is satisfied.

[Point 5-12]

The laser machining method according to Point 5-11, in which
the laser scan is performed such that DYave/DPave = 0.7 to 1.3 is satisfied.

[Point 5-13]

The laser machining method according to any one of Points 5-1 to 5-12, in which
the single laser scan includes relatively moving two of the laser beams different in position in the first direction with respect to the machining target, the two laser beams being the preceding beam and the following beam.

[Point 5-14]

The laser machining method according to Point 5-13, in which
the irradiation with the preceding beam and the irradiation with the following beam are simultaneously performed.

[Point 5-15]

The laser machining method according to any one of Points 5-1 to 5-14, in which

the irradiation marks are each formed of a modified region (RA) and a crack (C), the modified region being generated by a modification of the semiconductor material through the irradiation with the laser beam, the crack originating at the modified region, and
the crack includes a first-type crack developing in a direction inclined with respect to the surface by an off-angle (θ) and a second-type crack having an inclination closer to the surface than the first-type crack.

[Point 6-1]

A wafer manufacturing method of obtaining a wafer (1) from an ingot (2), the method including

a separation layer formation in which a separation layer (23) is formed at a depth corresponding to a thickness of the wafer from a surface (21) of the ingot on one end side in a height direction by irradiating the surface with a laser beam (B) which is transmissive to the surface, in which
in the separation layer formation,
the separation layer is formed by performing a laser scan for a plurality of times with changes in position within the surface in a second direction (Df) to form a plurality of irradiation trajectory lines (Ls) along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks (RM) of the laser beam and linear along the first direction, and
in the single laser scan, the irradiation marks are formed at a plurality of the respective irradiation positions by intermittently irradiating the irradiation with the laser beam with a relative movement of the laser beam relative to the ingot along the first direction, and a portion between a pair of the irradiation marks formed by an irradiation with a preceding beam (B1) and arrayed along the first direction is subjected to an irradiation with a following beam (B2) to join the irradiation marks formed by the irradiation with the preceding beam and the irradiation marks to be formed by the irradiation with the following beam, the preceding beam being the laser beam that precedes, the following beam being the laser beam that follows.

[Point 6-2]

The wafer manufacturing method according to Point 6-1, in which
the laser scan is performed between adjacent ones of the irradiation trajectory lines in the second direction.

[Point 6-3]

The wafer manufacturing method according to Point 6-1 or 6-2, in which

the ingot is a single crystal SiC ingot having a c-axis (Lc) and a C-plane (Pc) that are orthogonal to each other,
the c-axis is defined in a state where a center axis (L) orthogonal to the surface is inclined in an off-angle direction (Dθ) by an off-angle (θ) exceeding zero degrees, and
the first direction is parallel to the off-angle direction.

[Point 6-4]

The wafer manufacturing method according to any one of Points 6-1 to 6-3, in which
a direction of the relative movement is reversed between the single laser scan and the next single laser scan.

[Point 6-5]

The wafer manufacturing method according to any one of Points 6-1 to 6-4, in which
in the single laser scan, a plurality of the irradiation trajectory lines are formed by irradiating the surface with a plurality of the preceding beams and the following beams, the plurality of the preceding beams and the following beams being different in the irradiation position in the second direction.

[Point 6-6]

The wafer manufacturing method according to any one of Points 6-1 to 6-5, including
controlling an irradiation condition of the laser beam based on a measurement result of a transmittance of the laser beam through a material forming the ingot.

[Point 6-7]

The wafer manufacturing method according to Point 6-6, including

> obtaining a trend of change in the height direction of an absorption coefficient of the laser beam in the material based on the measurement result; and determining the irradiation condition based on the obtained trend of change.

[Point 6-8]

The wafer manufacturing method according to Point 6-6 or 6-7, in which
a measurement pitch for the transmittance is narrower at a boundary portion between a facet region (RF) and a non-facet region (RN) than at any other portion.

[Point 6-9]

The wafer manufacturing method according to any one of Points 6-1 to 6-8, in which

> the laser scan is performed such that DYave / DPave ≤ 5 is satisfied,
> where:
>
> > DY denotes a local maximum width in the second direction of a modified layer (RA) formed inside the ingot by the irradiation with the laser beam;
> > DP denotes a local maximum spacing in the first direction, the local maximum spacing being a spacing between the modified layer and adjacent another modified layer at a position corresponding to the local maximum width of the modified layer;
> > DYave denotes an average value of the local maximum width; and
> > DPave denotes an average value of the local maximum spacing.

[Point 6-10]

The wafer manufacturing method according to Point 6-9, in which
the laser scan is performed such that DYave/DPave ≤ 2 is satisfied.

[Point 6-11]

The wafer manufacturing method according to Point 6-10, in which
the laser scan is performed such that DYave/DPave = 0.7 to 1.3 is satisfied.

[Point 6-12]

The wafer manufacturing method according to any one of Points 6-1 to 6-11, in which

the single laser scan includes relatively moving two of the laser beams different in position in the first direction with respect to the ingot, the two laser beams being the preceding beam and the following beam.

[Point 6-13]

The wafer manufacturing method according to Point 6-12, in which
the irradiation with the preceding beam and the irradiation with the following beam are simultaneously performed.

[Point 6-14]

The wafer manufacturing method according to any one of Points 6-1 to 6-13, in which

> the irradiation marks are each formed of a modified region (RA) and a crack (C), the modified region being generated by a modification of the semiconductor material through the irradiation with the laser beam, the crack originating at the modified region, and
> the crack includes a first-type crack developing in a direction inclined with respect to the surface by an off-angle (θ) and a second-type crack having an inclination closer to the surface than the first-type crack.

**Claims**

1. A laser machining method of irradiating a machining target (2) made of a semiconductor material with a laser beam (B), the method comprising

> a modified layer formation in which a modified layer (RA) is formed at a predetermined depth from a surface (21) of the machining target by irradiating the surface with the laser beam which is transmissive to the surface, wherein
> in the modified layer formation,
> by performing a laser scan for a plurality of times with a change in position within the surface in a second direction (Df), a plurality of irradiation trajectory lines (Ls) are formed along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks of the laser beam and linear along the first direction, and
> in a single laser scan, the irradiation marks are formed at a plurality of the respective irradiation positions by intermittently irradiating with the laser beam with a relative movement of the laser beam relative to the machining target along the first direction, and the irradiation marks formed by the irradiation with the laser beam that precedes are irradiated with the laser beam that follows.

2. The laser machining method according to claim 1, wherein
the laser scan is performed between adjacent ones of the irradiation trajectory lines in the second direction.

3. The laser machining method according to claim 1, wherein

the machining target is a single crystal SiC having a c-axis (Lc) and a C-plane (Pc) that are orthogonal to each other,
the c-axis is defined in a state where a center axis (L) orthogonal to the surface is inclined in an off-angle direction (Dθ) by an off-angle (θ) exceeding zero degrees, and
the first direction is parallel to the off-angle direction.

4. The laser machining method according to claim 2, wherein
a direction of the relative movement is reversed between the single laser scan and the next single laser scan.

5. The laser machining method according to claim 1, wherein
in the single laser scan, the plurality of irradiation trajectory lines are formed by irradiating the surface with a plurality of the laser beams different at least in the irradiation position in the second direction.

6. The laser machining method according to claim 1, comprising
controlling an irradiation condition of the laser beam based on a measurement result of a transmittance of the laser beam through the semiconductor material.

7. The laser machining method according to claim 6, comprising:

obtaining a trend of change in a depth direction of an absorption coefficient of the laser beam in the semiconductor material based on the measurement result; and
determining the irradiation condition based on the obtained trend of change.

8. The laser machining method according to claim 6, wherein

a measurement pitch for the transmittance is narrower at a boundary portion between a facet region (RF) and a non-facet region (RN) than at any other portion.

9. The laser machining method according to claim 1, wherein
the machining target is a single crystal SiC ingot.

10. A wafer manufacturing method of obtaining a wafer (1) from an ingot (2), the method comprising

a separation layer formation in which a separation layer (23) is formed at a depth corresponding to a thickness of the wafer from a surface (21) of the ingot on one end side in a height direction by irradiating the surface with a laser beam which is transmissive to the surface, wherein
in the separation layer formation,
the separation layer is formed by performing a laser scan for a plurality of times with a change in position within the surface in a second direction (Df) to form a plurality of irradiation trajectory lines (Ls) along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks (RM) of the laser beam and linear along the first direction, and
in a single laser scan, the irradiation marks are formed at a plurality of the respective irradiation positions by intermittently irradiating with the laser beam with a relative movement of the laser beam relative to the ingot along the first direction, and the irradiation marks formed by the irradiation with the laser beam that precedes are irradiated with the laser beam that follows.

11. The wafer manufacturing method according to claim 10, wherein
the laser scan is performed between adjacent ones of the irradiation trajectory lines in the second direction.

12. The wafer manufacturing method according to claim 10, wherein

the ingot is a single crystal SiC ingot having a c-axis (Lc) and a C-plane (Pc) that are orthogonal to each other,
the c-axis is defined in a state where a center axis (L) orthogonal to the surface is inclined in an off-angle direction (Dθ) by an off-angle (θ) exceeding zero degrees, and

the first direction is parallel to the off-angle direction.

13. The wafer manufacturing method according to claim 11, wherein
a direction of the relative movement is reversed between the single laser scan and the next single laser scan.

14. The wafer manufacturing method according to claim 10, wherein
in the single laser scan, the plurality of irradiation trajectory lines are formed by irradiating the surface with a plurality of the laser beams different at least in the irradiation position in the second direction.

15. The wafer manufacturing method according to claim 10, comprising
controlling an irradiation condition of the laser beam based on a measurement result of a transmittance of the laser beam through a material forming the ingot.

16. The wafer manufacturing method according to claim 15, comprising:

obtaining a trend of change in the height direction of an absorption coefficient of the laser beam in the material based on the measurement result; and
determining the irradiation condition based on the obtained trend of change.

17. The wafer manufacturing method according to claim 15, wherein
a measurement pitch for the transmittance is narrower at a boundary portion between a facet region (RF) and a non-facet region (RN) than at any other portion.

18. The laser machining method according to claim 1, wherein

the laser scan is performed such that DYave / DPave ≤ 5 is satisfied,
where:

DY denotes a local maximum width in the second direction of the modified layer;
DP denotes a local maximum spacing in the first direction, the local maximum spacing being a spacing between the modified layer and adjacent another modified layer at a position corresponding to the local maximum width of the modified layer;
DYave denotes an average value of the local maximum width; and
DPave denotes an average value of the local maximum spacing.

19. The laser machining method according to claim 18, wherein
the laser scan is performed such that DYave/DPave ≤ 2 is satisfied.

20. The laser machining method according to claim 19, wherein
the laser scan is performed such that DYave/DPave = 0.7 to 1.3 is satisfied.

21. The wafer manufacturing method according to claim 10, wherein

the laser scan is performed such that DYave / DPave ≤ 5 is satisfied,
where:

DY denotes a local maximum width in the second direction of a modified layer (RA) formed inside the ingot by an irradiation with the laser beam;
DP denotes a local maximum spacing in the first direction, the local maximum spacing being a spacing between the modified layer and adjacent another modified layer at a position corresponding to the local maximum width of the modified layer;
DYave denotes an average value of the local maximum width; and
DPave denotes an average value of the local maximum spacing.

22. The wafer manufacturing method according to claim 21, wherein
the laser scan is performed such that DYave/DPave ≤ 2 is satisfied.

23. The wafer manufacturing method according to claim 22, wherein
the laser scan is performed such that DYave/DPave = 0.7 to 1.3 is satisfied.

24. A laser machining method of irradiating a machining target (2) made of a semiconductor material with a laser beam (B), the method comprising

a modified layer formation in which a modified layer (RA) is formed at a predetermined depth from a surface (21) of the machining target by irradiating the surface with the laser beam which is transmissive to the surface, wherein
in the modified layer formation,
by performing a laser scan for a plurality of times with a change in position within the surface in a second direction (Df), a plurality of irradiation trajectory lines (Ls) are formed along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks of the laser beam and linear along the first direction, and in a single laser scan, the irradiation marks are formed at a plurality of the respective irradiation positions by intermittently irradiating with the laser beam with a relative movement of the laser beam relative to the machining target along the first direction, and a portion between a pair of the irradiation marks formed by an irradiation with a preceding beam (B1) and arrayed along the first direction is subjected to an irradiation with a following beam (B2), the preceding beam being the laser beam that precedes, the following beam being the laser beam that follows.

25. The laser machining method according to claim 24, wherein
in the single laser scan, the irradiation with the preceding beam and the irradiation with the following beam are performed such that the irradiation marks formed by the irradiation with the preceding beam and the irradiation marks to be formed by the irradiation with the following beam are joined.

26. The laser machining method according to claim 24, wherein
the single laser scan includes relatively moving two of the laser beams different in position in the first direction with respect to the machining target, the two laser beams being the preceding beam and the following beam.

27. The laser machining method according to claim 26, wherein
the irradiation with the preceding beam and the irradiation with the following beam are simultaneously performed.

28. The laser machining method according to claim 24, wherein
in the single laser scan, the plurality of irradiation trajectory lines are formed by irradiating the surface with a plurality of the preceding beams and the following beams, the plurality of the preceding beams and the following beams being different in the irradiation position in the second direction.

29. The laser machining method according to claim 1 or 24, wherein

the irradiation marks are each formed by a modified region (RA) and a crack (C), the modified region being generated by a modification of the semiconductor material through an irradiation with the laser beam, the crack originating at the modified region, and
the crack includes a first-type crack developing in a direction inclined with respect to the surface by an off-angle ($\theta$) and a second-type crack having an inclination closer to the surface than the first-type crack.

30. A wafer manufacturing method of obtaining a wafer (1) from an ingot (2), the method comprising

a separation layer formation in which a separation layer (23) is formed at a depth corresponding to a thickness of the wafer from a surface (21) of the ingot on one end side in a height direction by irradiating the surface with a laser beam (B) which is transmissive to the surface, wherein
in the separation layer formation,
the separation layer is formed by performing a laser scan for a plurality of times with a change in position within the surface in a second direction (Df) to form a plurality of irradiation trajectory lines (Ls) along the second direction, the laser scan including irradiating the surface with the laser beam while moving an irradiation position (PR) of the laser beam within the surface along a first direction (Ds) defined along the surface, the second direction being orthogonal to the first direction and defined along the surface, the irradiation trajectory lines being made of irradiation marks (RM) of the laser beam and linear along the first direction, and
in a single laser scan, the irradiation marks are formed at a plurality of the respective irradiation positions by intermittently irradiating with the laser beam with a relative movement of the laser beam relative to the ingot along the first direction, and a portion between a pair of the irradiation marks formed by an irradiation with a preceding beam (B1) and arrayed along the first direction is subjected to an irradiation with a following beam (B2), the preceding beam being the laser beam that precedes, the following beam being the laser beam that follows.

31. The wafer manufacturing method according to claim 30, wherein
in the single laser scan, the irradiation with the preceding beam and the irradiation with the following beam are performed such that the irradiation marks formed by the irradiation with the preceding beam and the irradiation marks to be formed by the irradiation with the following beam are joined.

32. The wafer manufacturing method according to claim 30, wherein
the single laser scan includes relatively moving two of the laser beams different in position in the first direction with respect to the ingot, the two laser beams being the preceding beam and the following beam.

33. The wafer manufacturing method according to claim 32, wherein
the irradiation with the preceding beam and the irradiation with the following beam are simultaneously performed.

34. The wafer manufacturing method according to claim 30, wherein
in the single laser scan, the plurality of irradiation trajectory lines are formed by irradiating the surface with a plurality of the preceding beams and the following beams, the plurality of the preceding beams and the following beams being different in the irradiation position in the second direction.

35. The wafer manufacturing method according to claim 10 or 30, wherein

the irradiation marks are each formed of a modified region (RA) and a crack (C), the modified region being generated by a modification of a semiconductor material through an irradiation with the laser beam, the crack originating at the modified region, and
the crack includes a first-type crack (C1) developing in a direction inclined with respect to the surface by an off-angle ($\theta$) and a second-type crack (C2) having an inclination closer to the surface than the first-type crack.

# FIG.1

# FIG.2

INGOT

SEPARATION LAYER FORMATION

WAFER SEPARATION

WAFER ROUGH GRINDING

INGOT ROUGH GRINDING

WAFER ECMG

INGOT FINISH GRINDING

WAFER ECMP

INGOT CLEANING

WAFER CLEANING

EPI-READY WAFER

# FIG.3

# FIG.4

# FIG.5A

# FIG.5B

# FIG.6A

# FIG.6B

# FIG.6C

$D\theta$ →

PR

B

Ds →

2

21

BP

RA

C

RM

Pc

Z
Y ⊗ → X

# FIG.6D

$D\theta$ →

PR

B

Ds →

2

21

BP

RA

C

RM

Pc

W

Z
Y ⊗ → X

# FIG.6E

Ls

RA

# FIG.7A

# FIG.7B

# FIG.7C

# FIG.7D

# FIG.7E

Ls

RA

Y

Z → X

# FIG.7F

DP    DP    DP

DY    DY    DY    DY

Ls

RA

Y

Z → X

# FIG.8

# FIG.9

# FIG.10

# FIG.11

```
┌─────────────────────┐
│ LOADING/DISCHARGING │◄─────────┐
└─────────────────────┘          │
                                 │
┌─────────────────────┐          │
│    LASER SLICING    │          │
└─────────────────────┘          │
                                 │
┌─────────────────────┐          │
│  WAFER SEPARATION   │          │
└─────────────────────┘          │
                                 │
┌─────────────────────┐          │
│ WAFER BEVEL MACHINING│         │
└─────────────────────┘          │
                                 │
┌─────────────────────┐          │
│   ROUGH GRINDING    │          │
└─────────────────────┘          │
                                 │
┌─────────────────────┐          │
│   FINISH GRINDING   │          │
└─────────────────────┘          │
                                 │
┌─────────────────────┐          │
│   WAFER OPTICAL     │          │
│   MEASUREMENT       │          │
└─────────────────────┘          │
                                 │
┌─────────────────────┐          │
│   INGOT CLEANING    │          │
└─────────────────────┘          │
```

INGOT

WAFER

# FIG.12

RN

RF

100

Y

Z

X

# FIG.13

RN

RF

Lx

100

Y

Z

X

# FIG.14

# FIG.15A

# FIG.15B

# FIG.15C

# FIG.16

# FIG.17

# FIG.18A

# FIG.18B

# FIG.18C

# FIG.19

# FIG.20

# FIG.21

# FIG.22

# FIG.23

# FIG.24

PR

B

2

Pc

BP

RC

RA

C

RM

Z

Y

X

# FIG.25

PR

B

2

21

Pc

RC

RA

C

BP

RM

Z

Y

X

# FIG.26

# FIG.27

# FIG.28

$\xrightarrow{D\theta}$

2

21

C1   RA   C1   C2   C   C2   RA   C2

RM   RM

Z

Y   X

# EP 4 723 163 A1

## INTERNATIONAL SEARCH REPORT

International application No.

**PCT/JP2024/017303**

### A. CLASSIFICATION OF SUBJECT MATTER

*H01L 21/304*(2006.01)i; *B23K 26/00*(2014.01)i; *B23K 26/08*(2014.01)i; *B23K 26/53*(2014.01)i
FI: H01L21/304 611Z; B23K26/53; B23K26/00 N; B23K26/08 Z

According to International Patent Classification (IPC) or to both national classification and IPC

### B. FIELDS SEARCHED

Minimum documentation searched (classification system followed by classification symbols)

H01L21/304; B23K26/00; B23K26/08; B23K26/53

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2018-50066 A (EL-SEED CORPORATION) 29 March 2018 (2018-03-29)<br>paragraphs [0014]-[0024] | 1-35 |
| A | JP 2020-102522 A (HAMAMATSU PHOTONICS K.K.) 02 July 2020 (2020-07-02)<br>paragraphs [0032]-[0042] | 1-35 |
| A | JP 2015-123466 A (SHIN-ETSU POLYMER CO., LTD.) 06 July 2015 (2015-07-06)<br>paragraphs [0041]-[0043], fig. 6 | 1-35 |
| A | JP 2023-3693 A (DISCO CORPORATION) 17 January 2023 (2023-01-17)<br>paragraphs [0050]-[0060] | 6-8, 15-17 |
| P, X | JP 2024-42769 A (DISCO CORPORATION) 29 March 2024 (2024-03-29)<br>paragraphs [0021]-[0050] | 1 |
| P, A | | 2-35 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 July 2024** | **23 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

INTERNATIONAL SEARCH REPORT
Information on patent family members

International application No.

**PCT/JP2024/017303**

| Patent document cited in search report | | | Publication date (day/month/year) | Patent family member(s) | | | Publication date (day/month/year) |
|---|---|---|---|---|---|---|---|
| JP | 2018-50066 | A | 29 March 2018 | WO | 2017/199784 | A1 | |
| JP | 2020-102522 | A | 02 July 2020 | WO | 2020/130110 | A1 | |
| | | | | TW | 202032646 | A | |
| JP | 2015-123466 | A | 06 July 2015 | (Family: none) | | | |
| JP | 2023-3693 | A | 17 January 2023 | US | 2022/0410305 | A1 | |
| | | | | paragraphs [0061]-[0067] | | | |
| | | | | EP | 4109078 | A1 | |
| JP | 2024-42769 | A | 29 March 2024 | US | 2024/0100632 | A1 | |
| | | | | paragraphs [0021]-[0053] | | | |
| | | | | CN | 117727692 | A | |
| | | | | KR | 10-2024-0038594 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023087816 A
- JP 6482389 B
- JP 2016111143 A
- JP 2006130691 A
- JP 2014147946 A